# EUROPEAN PATENT SPECIFICATION

(11) **EP 4 629 287 B1**
(45) Date of publication and mention of the grant of the patent: **25.11.2026**
(21) Application number: 25166541.0
(22) Date of filing: 27.03.2025
(51) Int. Cl.: H10W 40/60, H05K 7/20, H05K 1/02, H10W 40/47

(54) **POWER DEVICE**
LEISTUNGSVORRICHTUNG
DISPOSITIF D'ALIMENTATION

(30) Priority: 01.04.2024 CN 202410390656
(43) Date of publication of application: 08.10.2025
(73) Proprietor: Huawei Digital Power Technologies Co., Ltd., Shenzhen, Guangdong 518043 (CN)
(72) Inventor: FA, Yangyang, Shenzhen, 518043 (CN); LI, Maofan, Shenzhen, 518043 (CN); YANG, Linhua, Shenzhen, 518043 (CN); CHEN, Yuanyang, Shenzhen, 518043 (CN); YANG, Qiuguo, Shenzhen, 518043 (CN)
(74) Representative: Gill Jennings & Every LLP

(56) References cited:
- CN-A- 114 867 280
- CN-A- 115 662 968
- US-A1- 2006 232 942
- US-A1- 2013 120 926
- US-A1- 2013 176 679
- US-A1- 2013 182 389
- US-A1- 2022 181 233

## Description

### TECHNICAL FIELD

This application relates to the field of power electronics technologies, and in particular, to a power device (1).

### BACKGROUND

Power components (for example, an IGBT or a MOSFET) are widely used in various industries. Because a power component generates a large amount of heat, how to effectively dissipate the heat is a problem that urgently needs to be resolved in a structure and heat design. However, a current manner of fastening and heat dissipation of the power component is mainly a connection to a heat sink through screw fastening or spring sheet clamping. Compared with screw fastening, spring sheet clamping has more advantages in resolving production compliance problems, and therefore is widely applied. For a solution of spring sheet clamping, how to properly control convenience and an amount of deformation and a yield risk of a spring sheet in an assembly process, to ensure a stable clamping force of the spring sheet on the power component is a research and development direction in the industry.

CN 115 662 968 A discloses spring-clamped power device packaging on compact heat-sink bracket. CN 114 867 280 A discloses tool-assisted assembly using elastic pressing sheet to clamp power device. US 2006/232942 A1 discloses power module mounting semiconductor devices to heat sink with elastic pressurizing. US 2022/181233 A1 discloses housing with convex radiator and urging member pressing heater toward radiator. US 2013/176679 A1 discloses liquid-cooled enclosure enabling hot-swappable component packages without interrupting coolant flow. US 2013/182389 A1 discloses removable liquid-cooled heat sink for interchangeable expansion modules on computer boards. US 2013/120926 A1 discloses user-serviceable liquid cooling for DIN4Ms using heat spreaders and heat pipes.

### SUMMARY

Embodiments of this application provide a power device (1), to effectively resolve a problem of a yield risk that is likely to be caused by an excessively large amount of elastic deformation of a spring sheet in an assembly process, and also better facilitate mounting of the spring sheet.

An embodiment of this application provides a power device (1), including a spring sheet, a power component, a circuit board, a guide support, and a heat dissipation structure fastened between the circuit board and the guide support. The power component includes a main body part and a pin. The pin is configured to connect to the circuit board. A first surface of the main body part faces and is connected to the heat dissipation structure. The guide support and the pin are distributed on two opposite sides of the main body part in a first direction. The guide support includes an outer side face disposed at an included angle with the first direction. The spring sheet includes a pressing part. The pressing part is configured to elastically press against a second surface of the main body part. The outer side face is configured to guide the pressing part to the second surface of the main body part. The first surface and the second surface are disposed opposite to each other in a second direction.

In this embodiment, in a process of mounting the spring sheet, the outer side face can guide the spring sheet to move and open, so that the pressing part of the spring sheet presses against the second surface of the main body part. Therefore, in the process of mounting the spring sheet, an amount of deformation of the spring sheet may be controlled by the outer side face of the guide support, so that a magnitude of an acting force exerted on the spring sheet due to deformation can be precisely controlled, to control the acting force exerted on the spring sheet to be always less than a force that causes yield deformation of the spring sheet. Therefore, in this embodiment, the spring sheet can be effectively controlled to avoid yield deformation while the spring sheet is precisely guided to a mounting position by the outer side face of the guide support.

In addition, in a related technology, an external device (for example, a robotic hand) usually applies an external force to make the spring sheet elastically deform and move to a position of the power component, and then releases the spring sheet. When the spring sheet is released, a large force is usually applied to the power component. This greatly increases a probability of damage to the power component. In this embodiment, the outer side face can also guide the pressing part to the second surface of the main body part. This can effectively avoid a large impact force suddenly applied to the power component under an action of an elastic force because the spring sheet loses control of the external force, thereby effectively avoiding damage to the power component caused by the spring sheet when the spring sheet is mounted.

In addition, in a related technology, an external device (for example, a robotic hand) usually applies an external force to make the spring sheet elastically deform. When the external device applies the external force to the spring sheet, the external force is usually excessively large, causing an excessively long expansion stroke and yield deformation of the spring sheet. Consequently, an acting force applied by the spring sheet to the power component may be less than that expected. Therefore, an elastic margin reduced due to yield deformation of the spring sheet is usually added in advance during design of the spring sheet. In this way, when yield deformation occurs on the spring sheet, a sufficient elastic force can still be applied to the power component. However, in this design, a force applied to the power component by the spring sheet free of yield deformation is excessively large, and consequently damage to the power component is likely to be caused. In this embodiment, because the amount of deformation of the spring sheet in the mounting process can be controlled in a range in which no yield deformation occurs, an elastic margin reduced due to yield deformation of the spring sheet does not need to be added in advance during design of the spring sheet, thereby avoiding damage to the power component due to excessively high pressure of the spring sheet on the power component. In addition, the additional elastic margin does not need to be considered during the design of the spring sheet, so that design difficulty is reduced, and costs are also correspondingly reduced.

The guide support includes a first end face and a second end face that are disposed opposite to each other in the first direction and an outer side face connected between the first end face and the second end face. An area enclosed by an outer contour of the first end face is less than an area enclosed by an outer contour of the second end face. The first end face is located on a side that is of the second end face and that is away from the main body part, and an included angle formed between the outer side face and the first end face is an obtuse angle. Because the included angle formed between the outer side face and the first end face is an obtuse angle, the guide support is characterized by a trapezoid that is narrow at the top and wide at the bottom, to effectively fit mounting of the spring sheet, provide a press-type mounting method for the spring sheet, and effectively resolve a problem of mounting difficulty of the spring sheet and a possible yield risk in the mounting process.

In some embodiments, the included angle formed between the outer side face and the first end face is B, and 92°≤B≤135°. In this range, the guide support characterized by a trapezoid that is narrow at the top and wide at the bottom can effectively fit mounting of the spring sheet, provide a press-type mounting method for the spring sheet, and effectively resolve the problem of mounting difficulty of the spring sheet and a possible yield risk in the mounting process.

In some embodiments, the outer side face includes a first edge connected to the first end face and a second edge connected to the second end face. In the first direction, the second end face is located between the first end face and the main body part, and an end that is of the outer side face and at which the second edge is disposed extends to an end that is of the main body part and that faces the guide support. In this implementation, the outer side face may guide the spring sheet to move from the first edge of the outer side face to the second edge of the outer side face and open. It can be learned that the amount of elastic deformation of the spring sheet gradually increases in a moving process. In addition, because the end that is of the outer side face and at which the second edge is disposed extends to the end that is of the main body part and that faces the guide support, the spring sheet may be further moved from the second edge of the outer side face to the main body part. Specifically, the pressing part is moved to the second surface of the main body part to press the main body part against the heat dissipation structure.

In some embodiments, the second direction is perpendicular to the first direction. The outer side face includes a first edge connected to the first end face and a second edge connected to the second end face. The second surface is located between the first surface and the second edge in the second direction. A distance between the second edge and the second surface in the second direction is L, and L is between 0 mm and 1 mm. L is in this range. This can avoid yield deformation due to excessively large elastic deformation of the spring sheet caused by the outer side face, and can make the pressing part of the spring sheet move naturally and smoothly from the outer side face to the second surface of the main body part, thereby improving mounting efficiency of the spring sheet.

The spring sheet includes a connection arm and a first spring arm connected to the connection arm. The first spring arm includes the pressing part. The connection arm is configured to connect to the first end face, and the outer side face is configured to increase an included angle between the connection arm and the first spring arm when the spring sheet is mounted. Because the connection arm is configured to connect to the first end face, and the outer side face is configured to increase the included angle between the connection arm and the first spring arm, the spring sheet can be precisely and quickly mounted in place.

In some embodiments, the first spring arm includes a first arc corner part and a first connection part. The first arc corner part is of a circular arc structure. The first arc corner part is connected between the connection arm and the first connection part. An end that is of the first connection part and that is away from the first arc corner part is connected to a pressing part of the first spring arm. In this implementation, a joint between the first spring arm and the connection arm is the first arc corner part in the circular arc shape. This can effectively improve an elastic deformation resistance capability of a part between the first spring arm and the connection arm, thereby increasing overall yield strength of the spring sheet.

In some embodiments, a joint between the second spring arm and the connection arm is a second arc corner part in a circular arc shape. This can effectively improve an elastic deformation resistance capability of a part between the second spring arm and the connection arm, thereby increasing overall yield strength of the spring sheet.

In some embodiments, a radius of the first arc corner part is R1, and 3 mm≤R1≤8 mm. R1 is in this range. This can ensure that high stress concentration is avoided in a machining process of the spring sheet, and can ensure that a size of the connection arm is not affected by the spring sheet due to excessive large ranges of R1 and R2.

In some embodiments, the pressing part of the first spring arm is a first pressing part. The first pressing part includes a first circular arc segment of a circular arc structure. An end of the first circular arc segment is connected to the end that is of the first connection part and that is away from the first arc corner part, and is tangent to the first connection part. The first circular arc segment is located on a side that is of the first connection part and that is away from the main body part, and the first circular arc segment presses against the second surface of the main body part. In this embodiment, because one end of the first circular arc segment is connected to the end part of the first connection part, and is tangent to the end part of the first connection part, after the spring sheet is mounted, a part that is of the spring sheet and that is in contact with the pressed power component may be a part in the first circular arc segment, to ensure that the part that is of the spring sheet and that is in contact with the power component is on an arc tangent line on which pressure of the first circular arc segment acts. In addition, because one end of the first circular arc segment is connected to the end part of the first connection part, and is tangent to the end part of the first connection part, even if a position shift occurs after the spring sheet is mounted, the acting force of the spring sheet on the power component remains in a vertical direction of the pressed power component, namely, a direction perpendicular to the second surface. In this way, positive pressure perpendicular to the pressed power component can still be provided, to ensure consistency of pressure directions. In addition, because one end of the first circular arc segment is connected to the end part of the first connection part, and is tangent to the end part of the first connection part, it can be further ensured that friction between the spring sheet and the outer side face of the guide support in the mounting process can be reduced when there is a deviation between the spring sheet and the pressed power component, thereby ensuring that the first circular arc segment can be smoothly mounted in through sliding without being affected by an excessively large friction force. In addition, because one end of the first circular arc segment is connected to the end part of the first connection part, and is tangent to the end part of the first connection part. When moving to a boundary region between the guide support and the power component, the spring sheet smoothly slides to the second surface of the power component through a large circular arc surface of the spring sheet, thereby avoiding strong vibration. Then, the spring sheet continues to slide under the pressure, to complete mounting. In the entire mounting process, excessive deformation of the spring sheet can be avoided.

In some embodiments, the guide support is of a long bar structure, and in a length direction of the guide support, a plurality of partition plates are spaced apart on the outer side face of the guide support. One first spring arm is disposed between two adjacent partition plates. In this implementation, the partition plates are disposed to limit a spring sheet between two adjacent partition plates. When a spring sheet is mounted, the spring sheet can be precisely and quickly guided to a required mounting position by using two adjacent partition plates and the outer side face. In addition, because the partition plate separates two adjacent spring sheets, a creepage distance between the two adjacent spring sheets can be effectively increased, to meet a production compliance standard.

In some embodiments, one end of an insulating heat-conducting plate in the first direction is disposed on a pipe support, and the other end of the insulating heat-conducting plate in the first direction extends to an inner stiffener structure. Through limiting of the inner stiffener structure and the pipe support in the first direction, the insulating heat-conducting plate can be prevented from rotating relative to a liquid cooling pipe during mounting of the spring sheet, to ensure smooth mounting of the spring sheet.

In some embodiments, the guide support includes two outer side faces: a first outer side face and a second outer side face. The first outer side face and the second outer side face are located on two opposite sides of the first end face in the second direction. The spring sheet further includes a second spring arm connected to the connection arm. The connection arm is connected between the first spring arm and the second spring arm in the second direction. There are two pressing parts of the spring sheet: the first pressing part and a second pressing part. The pressing part of the first spring arm is the first pressing part. The second spring arm includes the second pressing part. The first outer side face is configured to guide the first spring arm to a second surface of one main body part. The second outer side face is configured to guide the second spring arm to a second surface of another main body part.

In some embodiments, the heat dissipation structure includes the liquid cooling pipe and the pipe support. The pipe support may be disposed on the circuit board. The liquid cooling pipe includes a first attachment face that is configured to fit the power component and a second attachment face that is opposite to the first attachment face. In this implementation, power components may be attached on two sides (the first attachment face and the second attachment face) of the liquid cooling pipe, so that a quantity of power components that can be mounted on the liquid cooling pipe can be increased. When a same quantity of power components are mounted, lengths or the quantity of power components can be reduced, thereby facilitating miniaturization of the power device (1).

In some embodiments, both the first end face and the second end face are located between the first outer side face and the second outer side face in the second direction, and a width of the first end face in the second direction is less than a width of the second end face in the second direction. In this implementation, the width of the first end face in the second direction is less than the width of the second end face in the second direction, and both the first end face and the second end face are located between the first outer side face and the second outer side face. Therefore, the first outer side face, the second outer side face, the first end face, and the second end face integrally form a structure that approximates an isosceles trapezoid. Therefore, a shorter distance to the main body part indicates a longer distance between the first outer side face and the second outer side face in the second direction. Therefore, in this implementation, according to a characteristic that in the first direction, the distance between the first outer side face and the second outer side face in the second direction gradually changes, the first outer side face and the second outer side face can properly and precisely guide the spring sheet to move and open, and a value of the amount of deformation of the elastically deformed spring sheet can be controlled in a proper range, to avoid yield deformation of the spring sheet due to a large amount of deformation of the spring sheet which reduces the elastic force of the spring sheet.

In some embodiments, when the spring sheet is in a natural state, an opening is formed between the pressing part of the first spring arm and the pressing part of the second spring arm. In this implementation, when the spring sheet is in the natural state, the opening is formed between the pressing part of the first spring arm and the pressing part of the second spring arm. Therefore, the first spring arm and the second spring arm can be conveniently pressed on the first outer side face and the second outer side face through the opening. This can effectively facilitate mounting of the spring sheet.

In some embodiments, the pressing part of the first spring arm presses against a middle part of a second surface of one power component. The pressing part of the second spring arm presses against a middle part of the second surface of another power component. In this design, the power component can be more evenly subject to a force, and the first surface of the power component is more evenly subject to pressure when the first surface of the power component is attached to the liquid cooling pipe, to improve a heat dissipation effect of the liquid cooling pipe on the power component.

In some embodiments, the second spring arm includes a second arc corner part and a second connection part. The second arc corner part is connected between the connection arm and the second connection part. An end that is of the second connection part and that is away from the second arc corner part is connected to a second pressing part, and the first spring arm and the second spring arm are symmetrically disposed with respect to the connection arm. In this implementation, based on symmetrical disposing of the first spring arm and the second spring arm with respect to the connection arm, the pressing part of the first spring arm presses against a main body part of one power component, and the pressing part of the second spring arm presses against a main body part of another power component. By using the spring sheet in this implementation, the two power components located on two sides of the liquid cooling pipe can be pressed simultaneously, to effectively reduce a quantity of spring sheets. The guide support is provided with the first outer side face and the second outer side face, and a shorter distance to the main body part indicates a longer distance between the first outer side face and the second outer side face in the second direction. Therefore, a size of an opening between the first spring arm and the second spring arm of the spring sheet can gradually increase through guidance of the first outer side face and the second outer side face. Finally, the first outer side face and the second outer side face are used to move the pressing part of the first spring arm to a second surface of one power component, and move the pressing part of the second spring arm to a second surface of another power component. In addition, in the entire process of mounting the spring sheet, the spring sheet can be precisely mounted due to guidance of the first outer side face and the second outer side face, to prevent yield deformation of the spring sheet in the mounting process, and further prevent damage to the power component due to impact of a large force on the power component caused by sudden and dramatic deformation of the spring sheet. In addition, because the second spring arm and the first spring arm are symmetrically disposed relative to the connection arm, a main deformation position and a maximum-stress position of the spring sheet may be a central part of the connection arm on the top of the spring sheet. This effectively avoids yield deformation of the first spring arm and the second spring arm, so that a structure of the spring sheet more stable.

In some embodiments, a distance, in the second direction, between an end part that is of the first connection part and that is connected to the first arc corner part and an end part that is of the second connection part and that is connected to the second arc corner part is L1, and a range of L1 is 16 mm≤L1≤40 mm. In this range, it can be ensured that a length of the connection arm in the second direction is long enough, so that a maximum-deformation part of the spring sheet after mounting is completed is a central part of the connection arm. This can effectively improve yield strength of the spring sheet.

In some embodiments, an included angle A1 is formed between the connection arm and the first connection part, and 45 degrees<A1<90 degrees. In this implementation, the entire spring sheet is approximately in an inverted trapezoid shape, and A1 is in this range, so that the pressing part at a lower end of the spring sheet presses against the power components more conveniently. A1 is in this range with reference to a requirement for a range of L1. This can also ensure a sufficient length of the connection arm in the second direction, to reduce overall stress rigidity and elastic rigidity of the spring sheet, so that the spring sheet can obtain a larger amount of deformation in a yield range, thereby reducing impact of a tolerance and an error during production and manufacturing of the spring sheet.

In some embodiments, a length of the first connection part in the first direction is L2, and a range of L2 satisfies 20 mm≤L2≤40 mm. In this range, it can be ensured that the spring sheet provides sufficient deformation space, and bending instability of the connection arm of the spring sheet is effectively avoided.

In some embodiments, the power device (1) further includes an insulating heat-conducting plate. The insulating heat-conducting plate is disposed between the main body part and the heat dissipation structure. The first outer side face, the second outer side face, and the first end face form an accommodation region by enclosing, and a part of the insulating heat-conducting plate extends from the second end face to the accommodation region. In this embodiment, the insulating heat-conducting plate is disposed to improve heat conduction efficiency between the power component and the liquid cooling pipe, thereby effectively improving the heat dissipation effect of the liquid cooling pipe on the power component. In addition, the insulating heat-conducting plate is disposed to increase a contact area between the insulating heat-conducting plate and the power component, thereby improving the heat dissipation effect of the liquid cooling pipe on the power component. In addition, because a part of the insulating heat-conducting plate extends from the second end face to the accommodation region, a creepage distance between the connection arm of the spring sheet and the power component can be effectively increased, thereby improving use safety.

In some embodiments, the power device (1) further includes a pressing rod. The pressing rod is fastened to the guide support, and is configured to fasten the mounted spring sheet to the guide support. In this implementation, the pressing rod is disposed to fasten a plurality of spring sheets to the guide support, and it is not necessary to fasten each spring sheet by using a bolt or the like. This simplifies an assembly process.

In some embodiments, the connection arm is of a long bar structure whose length direction is the same as the length direction of the guide support. The connection arm includes two opposite long edges in the second direction. A plurality of first spring arms are spaced apart on and connected to one of the long edges, and a plurality of second spring arms are spaced apart on and connected to the other of the long edges of the connection arm. Each first spring arm and each second spring arm of the spring sheet in this embodiment can press against one power component, so that the spring sheets in this embodiment can simultaneously press against a plurality of power components, and mounting of the spring sheets is faster and more convenient than that in the foregoing embodiments. In addition, the plurality of first spring arms and the plurality of second spring arms are simultaneously connected to the connection arm. Even if a deviation occurs during mounting of different first spring arms and second spring arms or a tolerance exists during production of different first spring arms and second spring arms, because the plurality of first spring arms and the plurality of second spring arms are a whole and can interact with each other, impact caused by the deviation during mounting or the tolerance during production can be effectively eliminated.

In some embodiments, a fastener is disposed at each end of the guide support in a length direction, and the two fasteners are configured to be respectively engaged with and connected to two ends in the length direction of the connection arm after mounting is completed. The power device (1) in this embodiment has a simple structure. When the spring sheet is mounted, the spring sheet can be directly pressed to a specified position to be engaged and fastened, so that mounting is more convenient.

In some embodiments, the connection arm is of a long bar structure whose length direction is the same as the length direction of the guide support. The connection arm includes two opposite long edges in the second direction. A plurality of first spring arms are spaced apart on and connected to one of the long edges. A guide hole is provided on the connection arm. A guide post protruding in the first direction is disposed on the first end face of the guide support, and the guide post is configured to fit the guide hole. In this embodiment, under an action of limiting of the guide post, when the guide hole is sleeved on the guide post and the connection arm is pressed down, the first spring arm is elastically deformed as the outer side face of the guide support gradually extends, so that a sufficient elastic force can be generated to press against the power component, to fasten the power component.

In some embodiments, the guide post is provided with an external thread. After the spring sheet is mounted, the spring sheet may be fastened to the guide support through a threaded connection between a nut and the guide post.

In some embodiments, the heat dissipation structure and the guide support are integrally disposed. The heat dissipation structure includes a substrate, a heat dissipation plate that is in parallel with and spaced from the substrate, and a connection plate that connects the heat dissipation plate to the substrate. The heat dissipation plate is located between the guide support and the connection plate in the first direction, and the power component is disposed on the heat dissipation plate. The heat dissipation structure in this embodiment mainly dissipates heat by using the heat dissipation plates, to satisfy a working scenario in which a heat dissipation requirement is not very high. In addition, because the heat dissipation structure and the guide support are integrally formed, overall strength can be improved.

In some embodiments, the first direction is in parallel with the circuit board, and the circuit board is connected to the heat dissipation structure and is disposed in parallel with and spaced from the substrate. Because the first direction is in parallel with the circuit board, and the circuit board is connected to the heat dissipation structure and is disposed in parallel with and spaced from the substrate, a size of the power device (1) can be effectively reduced in the second direction, so that the power device (1) is used in a working scenario in which a small size of the power device (1) in the second direction is required.

In some embodiments, there are a plurality of power components. The plurality of power components include a first power component and a second power component. There are a plurality of guide supports. The plurality of guide supports include a first guide support and a second guide support. There are a plurality of heat dissipation structures. The plurality of heat dissipation structures include a first heat dissipation structure and a second heat dissipation structure. The first heat dissipation structure and the second heat dissipation structure are spaced in the second direction, and the spring sheet is located between the first heat dissipation structure and the second heat dissipation structure in the second direction. The spring sheet includes a first pressing part and a second pressing part. The first pressing part is configured to elastically press against a second surface of the first power component. An outer side face of the first guide support is configured to: guide the spring sheet to move and open in a process of mounting the spring sheet, and guide the first pressing part to the second surface of the first power component. The second pressing part is configured to elastically press against a second surface of the second power component. An outer side face of the second guide support is configured to: guide the spring sheet to move and open in the process of mounting the spring sheet, and guide the second pressing part to the second surface of the second power component. The power device in this embodiment is applicable to a working scenario in which there are a plurality of heat dissipation structures and a distance between the heat dissipation structures is long.

In some embodiments, the spring sheet includes a first spring arm, a second spring arm, and a connection arm connected between the first spring arm and the second spring arm in the second direction. There are a plurality of pressing parts of the spring sheet. The plurality of pressing parts include a first pressing part and a second pressing part. The first spring arm includes a first connection part and a first pressing part. The first connection part is connected between the first pressing part and the connection arm. The second spring arm includes a second connection part and a second pressing part. The second connection part is connected between the second pressing part and the connection arm. An included angle formed between the first connection part and the connection arm is an obtuse angle, and an included angle formed between the second connection part and the connection arm is an obtuse angle. The connection arm is connected to the circuit board. In this embodiment, the included angle formed between the first connection part and the connection arm is an obtuse angle, and the included angle formed between the second connection part and the connection arm is an obtuse angle. The spring sheet is mounted in a reverse expansion manner. In a mounting process of the spring sheet, the included angle formed between the first connection part of the first spring arm and the connection arm gradually decreases, and the included angle formed between the second connection part of the second spring arm and the connection arm gradually decreases, so that the inverted U-shaped spring sheet is pressed down along the outer side face of the first guide support and the outer side face of the second guide support, to complete mounting.

### BRIEF DESCRIPTION OF DRAWINGS

FIG. 1 is a diagram of a structure of a power device according to an embodiment of this application;
FIG. 2 is a diagram of a structure of a mounting structure of a power component according to an embodiment of this application;
FIG. 3 is an exploded view of the mounting structure of the power component in the embodiment in FIG. 2;
FIG. 4 is a diagram of another angle of view of a structure of a guide support in the mounting structure of the power component in the embodiment in FIG. 3;
FIG. 5 is a sectional view of the guide support in the embodiment in FIG. 4;
FIG. 6 is a sectional view of the mounting structure of the power component in the embodiment in FIG. 2;
FIG. 6A is a sectional view of the mounting structure of the power component in the embodiment in FIG. 2;
FIG. 7 is a diagram of a structure obtained when a spring sheet of the mounting structure of the power component in the embodiment in FIG. 2 starts to be mounted;
FIG. 8 is a sectional view of the mounting structure of the power component in FIG. 7;
FIG. 9 is a diagram of a structure of the mounting structure of the power component in the embodiment in FIG. 2 in a mounting process;
FIG. 10 is a sectional view of the mounting structure of the power component in FIG. 9;
FIG. 11 is a front view of a spring sheet according to an embodiment of this application;
FIG. 11A is a front view of another spring sheet according to an embodiment of this application;
FIG. 11B is a front view of still another spring sheet according to an embodiment of this application;
FIG. 11C is a front view of still another spring sheet according to an embodiment of this application;
FIG. 12 is a diagram of a structure of another mounting structure of a power component according to an embodiment of this application;
FIG. 13 is an exploded view of the mounting structure of the power component in FIG. 12;
FIG. 14 is a partially enlarged diagram of A in FIG. 12;
FIG. 15 is a diagram of a structure of still another mounting structure of a power component according to an embodiment of this application;
FIG. 16 is a schematic exploded view of the mounting structure of the power component in FIG. 15;
FIG. 17 is a sectional view of the mounting structure of the power component in FIG. 15;
FIG. 18 is a diagram of a structure of still another mounting structure of a power component according to an embodiment of this application;
FIG. 19 is a schematic exploded view of the mounting structure of the power component in FIG. 18;
FIG. 20 is a diagram of a structure of still another mounting structure of a power component according to an embodiment of this application;
FIG. 21 is a front view of the mounting structure of the power component in FIG. 20; and
FIG. 22 is a schematic exploded view of the mounting structure of the power component in FIG. 20.

### Reference numerals:

Z: First direction; X: Second direction; Y: Length direction of a guide support;
1: Power device; 2: Housing; 2a: Inlet; 2b: Outlet; 3: Mounting structure of a power component; 4: Pipe;
10: Circuit board;
20: Heat dissipation structure; 21: Liquid cooling pipe; 211: First attachment face; 212: Second attachment face; 22: Pipe support; 23: Substrate; 24: Heat dissipation plate; 25: Connection plate; 20a: First heat dissipation structure; 20b: Second heat dissipation structure;
30: Power component; 31: Main body part; 311: First surface; 312: Second surface; 32: Pin; 30a: First power component; 30b: Second power component;
40: Spring sheet; 401: Pressing part; 41: First spring arm; 411: First arc corner part; 412: First pressing part; 4121: First circular arc segment; 413: First connection part; 42: Second spring arm; 421: Second arc corner part; 422: Second pressing part; 4221: Second circular arc segment; 423: Second connection part; 43: Connection arm; 431: Guide hole;
50: Guide support; 51: Outer side face; 511: First edge; 512: Second edge; 52: First end face; 53: Second end face; 54: First outer side face; 55: Second outer side face; 56: Top plate; 57: First side plate; 58: Second side plate; 501: Partition plate; 502: Inner stiffener structure; 503: Guide post; 504: Accommodation region; 505: Heat dissipation through hole; 50a: First guide support; 50b: Second guide support;
60: Insulating heat-conducting plate;
70: Pressing rod; 701: Fixing hole; 72: Fastener.

### DESCRIPTION OF EMBODIMENTS

### Term explanation:

Perpendicularity: Perpendicularity defined in this application is not limited to an absolute perpendicular (an included angle is 90 degrees) relationship. A non-absolute perpendicular intersection relationship caused by factors such as impact of an assembly tolerance, a design tolerance, and structural flatness is allowed. An error in a small angle range is allowed. For example, an intersection relationship in an assembly error range of 80 degrees to 100 degrees may be understood as a perpendicular relationship.

Parallelism: Parallelism defined in this application is not limited to absolute parallelism. A definition of the parallelism may be understood as basic parallelism. A case of non-absolute parallelism caused by factors such as impact of an assembly tolerance, a design tolerance, and structural flatness is allowed. For example, a relationship in an assembly error range of -10 degrees to 10 degrees may be understood as a parallel relationship.

The following describes possible implementations of this application with reference to the accompanying drawings in the possible implementations of this application.

An embodiment of this application provides a diagram of a structure of a power device. The power device in this embodiment may be a power converter like an inverter, or may be another device provided with a power component, for example, a power device used in the field of energy storage or the field of automobiles. The power device in this embodiment of this application can provide good heat dissipation performance for the power component, facilitate assembly, and can properly protect the power component from damage during assembly.

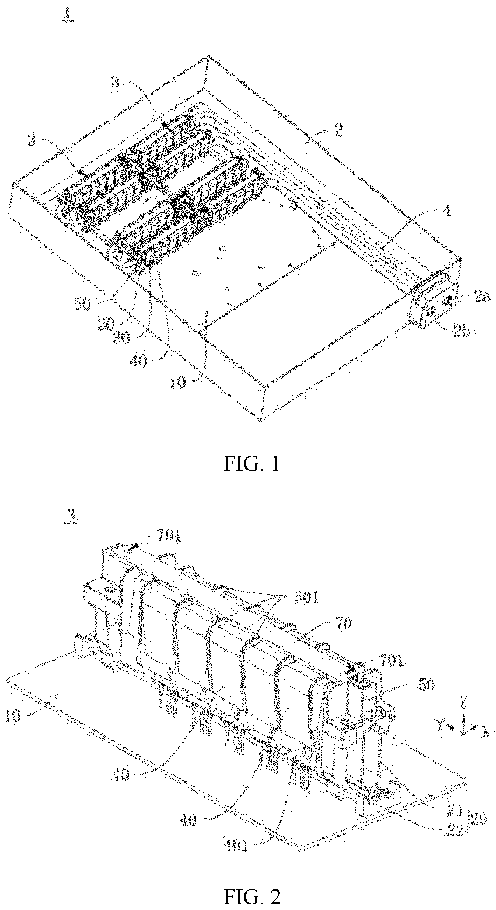

FIG. 1 is a diagram of a structure of a power device 1 according to an embodiment of this application.

Refer to FIG. 1. The power device 1 includes a housing 2 and a mounting structure 3 of a power component mounted in the housing 2. The mounting structure 3 of the power component includes a circuit board 10, a heat dissipation structure 20, a power component 30, and a spring sheet 40. The circuit board 10 is configured to electrically connect to a pin of the power component 30. The heat dissipation structure 20 is configured to dissipate heat for the power component 30. The spring sheet 40 is configured to fasten the power component 30 to the heat dissipation structure 20. For example, the power component 30 is attached to the heat dissipation structure 20 first, and then the power component 30 is fastened to the heat dissipation structure 20 by using the spring sheet 40, to improve a heat dissipation effect of the heat dissipation structure 20 on the power component 30.

In some implementations, the power component 30 may be an insulated gate bipolar transistor (Insulated Gate Bipolar Transistor, IGBT). In some implementations, the power component 30 may alternatively be a semiconductor field-effect transistor (a Metal-Oxide-Semiconductor Field-Effect Transistor, MOSFET). Certainly, in some other implementations, the power component 30 may alternatively be some other high-power components 30.

It may be understood that a quantity of power components 30 is not limited in this embodiment. For example, in some implementations, there may be one power component 30. In some implementations, there may alternatively be a plurality of power components 30, and the plurality of power components 30 may be arranged in a plurality of rows.

In some implementations, the heat dissipation structure 20 dissipates heat for the power component 30 in a liquid cooling manner, to improve a heat dissipation capability for the power component 30.

It may be understood that a quantity of heat dissipation structures 20 is not limited in this embodiment. For example, in some implementations, there may be one heat dissipation structure 20. In some implementations, there may alternatively be a plurality of heat dissipation structures 20. A quantity of power components 30 mounted on each heat dissipation structure 20 is not limited either. For example, in some implementations, one power component 30 is fastened to each heat dissipation structure 20 by using the spring sheet 40. In some implementations, a plurality of power components 30 may be fastened to each heat dissipation structure 20 by using the spring sheet 40. Each spring sheet 40 may fasten only one power component 30 to the heat dissipation structure 20, or each spring sheet 40 may fasten a plurality of power components 30 to the heat dissipation structure 20.

In some implementations, when there are a plurality of heat dissipation structures 20, the plurality of heat dissipation structures 20 may be connected in series through a pipe 4. An inlet 2a and an outlet 2b are provided on the housing 2 of the power device 1. The inlet 2a is configured to transport a liquid cooling medium (for example, water) to the heat dissipation structure 20 through the pipe 4, and the outlet 2b is configured to output the liquid cooling medium in the heat dissipation structure 20, to implement circulation of the liquid cooling medium in the plurality of heat dissipation structures 20, thereby improving the heat dissipation effect on the power component 30.

For the spring sheet 40 through which the power component 30 is mounted on the heat dissipation structure 20, the spring sheet 40 usually needs to have a large yield force, to prevent the spring sheet 40 from having a risk of yield deformation during mounting, and avoid a case in which the heat dissipation effect is reduced because the spring sheet 40 cannot make the power component 30 closely attach to the heat dissipation structure 20.

However, when the spring sheet 40 has a large yield force, during mounting, the spring sheet 40 is likely to apply excessively high pressure to the power component 30 or apply a large impact force at an instant due to an improper mounting manner. As a result, there is a risk of damaging the power component 30.

In some implementations, the mounting structure 3 of the power component further includes a guide support 50. The guide support 50 is mounted on the heat dissipation structure 20. The guide support 50 is a guide structure for mounting the spring sheet 40, and can precisely guide the spring sheet 40 to be mounted to a proper position.

According to the power device 1 in this embodiment of this application, the mounting structure 3 of the power component is properly disposed, for example, the guide support 50 for guiding the spring sheet 40 to be mounted is disposed, to implement precise assembly of the spring sheet 40, so that the power component 30 can be subject to proper pressure. In this way, the power component 30 can be closely attached to the heat dissipation structure 20 to improve heat dissipation efficiency. In addition, due to guidance of the guide support 50, the spring sheet 40 can be prevented from applying excessively high pressure to the power component 30 or applying a large impact force at an instant, to effectively reduce the risk of damaging the power component 30.

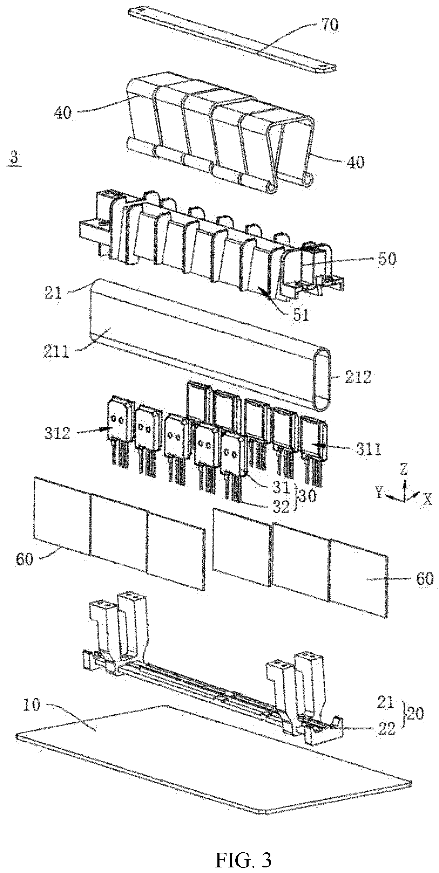

FIG. 2 is a diagram of a structure of a mounting structure 3 of a power component according to an embodiment of this application. FIG. 3 is an exploded view of the mounting structure 3 of the power component in the embodiment in FIG. 2. The mounting structure 3 of the power component in the embodiment in FIG. 2 is applicable to the power device 1 in the embodiment in FIG. 1, and is also applicable to another power device 1.

Similar to the mounting structure 3 of the power component in the embodiment in FIG. 1, with reference to FIG. 2 and FIG. 3, the mounting structure 3 of the power component in this embodiment also includes structures such as a circuit board 10, a heat dissipation structure 20, a power component 30, a guide structure, and a spring sheet 40.

In some embodiments, the heat dissipation structure 20 includes a liquid cooling pipe 21 and a pipe support 22. The pipe support 22 may be disposed on the circuit board 10. The pipe support 22 is of a long bar structure, and the liquid cooling pipe is of a long bar structure. The liquid cooling pipe is mounted on the pipe support 22, and a length direction of the liquid cooling pipe is the same as a length direction of the pipe support 22.

In some implementations, the liquid cooling pipe includes a first attachment face 211 that is configured to attach to the power component 30. For example, in some implementations, an extension direction of a long edge of the first attachment face 211 is consistent with the length direction of the liquid cooling pipe. A plurality of power components 30 may be attached to the first attachment face 211. Certainly, one power component 30 may alternatively be disposed on the first attachment face 211.

For example, in some implementations, the first attachment face 211 may be a flat surface. For example, the first surface 311 may be a rectangular surface, so that the plurality of power components 30 can be regularly attached to the first attachment face 211 of the liquid cooling pipe in a row. It may be understood that, in some other implementations, the first surface 311 may alternatively be a curved surface.

In some implementations, the liquid cooling pipe further includes a second attachment face 212 opposite to the first attachment face 211. In this implementation, power components 30 may be attached on two sides (the first attachment face 211 and the second attachment face 212) of the liquid cooling pipe, so that a quantity of power components 30 that can be mounted on the liquid cooling pipe can be increased. When a same quantity of power components 30 are mounted, lengths or the quantity of power components 30 can be reduced, thereby facilitating miniaturization of the power device 1.

In some implementations, in a length direction perpendicular to the length direction of the liquid cooling pipe, a cross section of the liquid cooling pipe is approximately in a waist shape, and the first attachment face 211 and the second attachment face 212 are located on two opposite sides of the liquid cooling pipe in the second direction X. Certainly, in some other implementations, in a length direction perpendicular to the length direction of the liquid cooling pipe, a cross section of the liquid cooling pipe is approximately in another shape, for example a rectangle or a square.

In some implementations, an arrangement direction of the liquid cooling pipe and the pipe support 22 is the same as a height direction of a housing 2 of the power device 1, and the first attachment face 211 and the second attachment face 212 are perpendicular to the height direction of the housing 2. In this design, more rows of liquid cooling pipes can be placed in the housing 2, so that more power components 30 can be properly accommodated in the housing 2.

To further improve a heat dissipation effect of the heat dissipation structure 20 on the power component 30, in some implementations, the heat dissipation structure 20 further includes an insulating heat-conducting plate 60, and the insulating heat-conducting plate 60 is disposed between the liquid cooling pipe of the heat dissipation structure 20 and the power component 30. The insulating heat-conducting plate 60 is disposed to improve heat conduction efficiency between the power component 30 and the liquid cooling pipe, thereby effectively improving the heat dissipation effect of the liquid cooling pipe on the power component 30. In addition, the insulating heat-conducting plate 60 is disposed to increase a contact area between the insulating heat-conducting plate 60 and the power component 30, thereby improving the heat dissipation effect of the liquid cooling pipe on the power component 30. It may be understood that, in some implementations, two power components 30 may be correspondingly disposed on each insulating heat-conducting plate 60. In some other implementations, only one power component 30 may alternatively be disposed on each insulating heat-conducting plate 60, or more than two power components 30 may be disposed on each insulating heat-conducting plate 60.

In some implementations, the insulating heat-conducting plate 60 is bonded to the liquid cooling pipe, for example, is attached to the liquid cooling pipe by using a bonding force of silicone grease, to fasten the insulating heat-conducting plate 60 to the liquid cooling pipe.

In some implementations, the power component 30 is bonded to the insulating heat-conducting plate 60, for example, bonded to the insulating heat-conducting plate 60 by using a thermal adhesive. The power component 30 and the insulating heat-conducting plate 60 are fastened together through bonding, which facilitates subsequent mounting of the spring sheet 40.

For example, in some implementations, the insulating heat-conducting plate 60 is disposed between the first attachment face 211 and the power component 30 disposed on the first attachment face 211, or is disposed between the second attachment face 212 and the power component 30 disposed on the second attachment face 212.

In some implementations, the insulating heat-conducting plate 60 is a ceramic piece, to improve a heat conducting capability and effectively reduce a risk of a short circuit between the power components 30.

It may be understood that, in some other implementations, the heat dissipation structure 20 may alternatively be disposed on the housing 2 of the power device 1, and is separated from the circuit board 10.

In some embodiments, the power component 30 includes a main body part 31 and a pin 32. The pin 32 is fastened to the circuit board 10. The main body part 31 includes a first surface 311. The first surface 311 of the main body part 31 faces and is connected to the heat dissipation structure 20.

For example, in some implementations, the first surface 311 may be directly connected to the first attachment face 211 or the second attachment face 212. For another example, in some implementations, the first surface 311 may alternatively be connected to the first attachment face 211 or the second attachment face 212 through the insulating heat-conducting plate 60.

In some implementations, in the length direction of the liquid cooling pipe, the plurality of power components 30 are spaced apart on the first attachment face 211.

In some implementations, in the length direction of the liquid cooling pipe, the plurality of power components 30 are spaced apart on the second attachment face 212.

In some implementations, the main body part 31 further includes a second surface 312 opposite to the first surface 311 in the second direction X. The second surface 312 is configured to fit the spring sheet 40, to fasten the main body part 31 to the heat dissipation structure 20 by using the spring sheet 40.

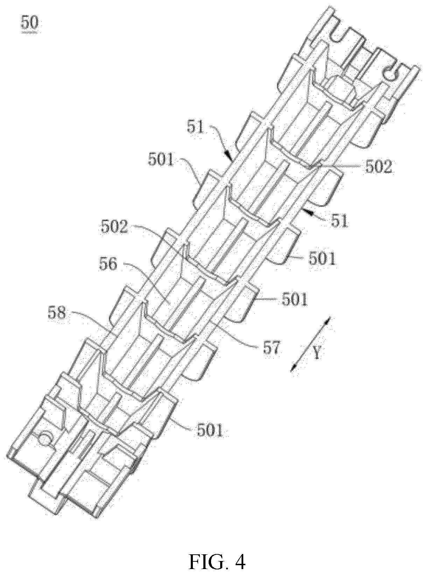

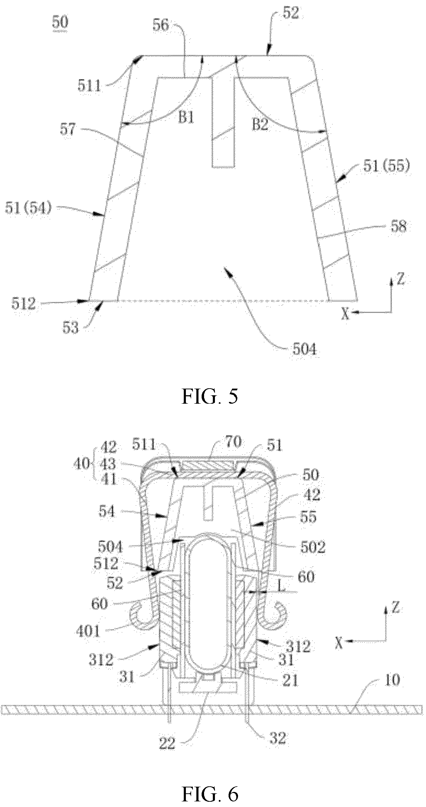

FIG. 4 is a diagram of another angle of view of a structure of the guide support 50 in the mounting structure 3 of the power component in the embodiment in FIG. 3. FIG. 5 is a sectional view of the guide support 50 in the embodiment in FIG. 4.

Refer to FIG. 2 to FIG. 5. In some embodiments, the guide support 50 includes an outer side face 51 configured to guide the spring sheet 40 to be precisely mounted.

For example, in some implementations, the guide support 50 further includes a first end face 52 and a second end face 53 that are disposed opposite to each other in a first direction Z. An area enclosed by an outer contour of the first end face 52 is less than an area enclosed by an outer contour of the second end face 53. The outer side face 51 is connected between the first end face 52 and the second end face 53, and the outer side face 51 forms an included angle with an extension direction of the first end face 52 in the first direction Z, and forms an included angle with an extension direction of the second end face 53 in the first directionZ. It may be understood that, in this implementation, there may be one or two opposite outer side faces 51 configured to guide the spring sheet 40. For example, when the power component 30 is mounted on only the first attachment face 211, only one outer side face 51 may be disposed on the guide support 50. When the power component 30 is mounted on both the first attachment face 211 and the second attachment face 212, two outer side faces 51 may be disposed on the guide support 50.

In some implementations, the guide support 50 is approximately in a long bar shape, and in a direction perpendicular to a length direction Y of the guide support 50, a shape of a cross section of the guide support 50 is approximately a trapezoid. For example, in some implementations, the cross section of the guide support 50 is an isosceles trapezoid. In this case, the guide support 50 in this implementation may include two outer side faces 51 configured to guide the spring sheet 40, and two edges of the isosceles trapezoid are respectively located on the two outer side faces 51. For another example, in some implementations, the cross section of the guide support 50 may alternatively be a right-angled trapezoid. In this case, the guide support 50 in this implementation may include one outer side face 51 configured to guide the spring sheet 40, and a non-right-angled side face of the right-angled trapezoid is located on the outer side face 51.

In some implementations, the guide support 50 includes an accommodation region 504 formed by a concave from the second end face 53 to the first end face 52, and the accommodation region 504 of the guide support 50 is configured to accommodate the liquid cooling pipe. In some implementations, the guide support 50 may be connected to the pipe support 22. It may be understood that, in some other implementations, the guide support 50 may alternatively be connected to the circuit board 10 or the housing 2 of the power device 1, or directly connected to the liquid cooling pipe.

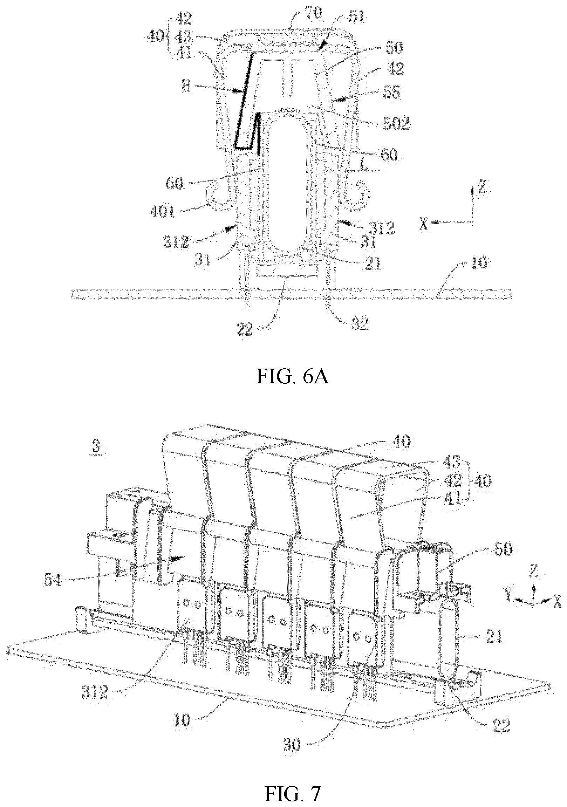

In some implementations, a part of the insulating heat-conducting plate 60 extends from the second end face 53 to the accommodation region 504. Because the part of the insulating heat-conducting plate 60 extends from the second end face 53 to the accommodation region 504, a creepage distance between a connection arm 43 (refer to FIG. 6A in the following) of the spring sheet 40 and the power component 30 can be effectively increased, thereby improving use safety.

In some implementations, the length direction Y of the guide support 50 is the same as the length direction of the liquid cooling pipe 21.

FIG. 6 is a sectional view of the mounting structure 3 of the power component in the embodiment in FIG. 2. The mounting structure 3 of the power component in the embodiment in FIG. 2 is in a state existing when mounting is completed.

Refer to FIG. 2 to FIG. 6. In some embodiments, the guide support 50 and the pin 32 are distributed on two opposite sides of the main body part 31 in the first direction Z. The spring sheet 40 includes a pressing part 401. The pressing part 401 is configured to elastically press against the second surface 312 of the main body part 31. The outer side face 51 is configured to: guide the spring sheet 40 to move and open in a process of mounting the spring sheet 40, and guide the pressing part 401 to the second surface 312 of the main body part 31. The first surface 311 and the second surface 312 are disposed opposite to each other. In this embodiment, in the process of mounting the spring sheet 40, the outer side face 51 can guide the spring sheet 40 to move and open, so that the pressing part 401 of the spring sheet 40 presses against the second surface 312 of the main body part 31. Therefore, in the process of mounting the spring sheet 40, an amount of deformation of the spring sheet 40 may be controlled by the outer side face 51 of the guide support 50, so that a magnitude of an acting force exerted on the spring sheet 40 due to deformation can be precisely controlled, to control the acting force exerted on the spring sheet 40 to be always less than a force that causes yield deformation of the spring sheet 40. Therefore, in this embodiment, the spring sheet 40 can be effectively controlled to avoid yield deformation while the spring sheet 40 is precisely guided to a mounting position by the outer side face 51 of the guide support 50.

In addition, in a related technology, an external device (for example, a robotic hand) usually applies an external force to make the spring sheet 40 elastically deform and move to a position of the power component 30, and then releases the spring sheet 40. When the spring sheet 40 is released, a large force is usually applied to the power component 30. This greatly increases a probability of damage to the power component 30. In this embodiment, the outer side face 51 can also guide the pressing part 401 to the second surface 312 of the main body part 31. This can effectively avoid a large impact force suddenly applied to the power component 30 under an action of an elastic force because the spring sheet 40 loses control of the external force, thereby effectively avoiding damage to the power component 30 caused by the spring sheet 40 when the spring sheet 40 is mounted.

In addition, in a related technology, an external device (for example, a robotic hand) usually applies an external force to make the spring sheet 40 elastically deform. When the external device applies the external force to the spring sheet 40, the external force is usually excessively large, causing an excessively long expansion stroke and yield deformation of the spring sheet 40. Consequently, an acting force applied by the spring sheet 40 to the power component 30 may be less than that expected. Therefore, an elastic margin reduced due to yield deformation of the spring sheet 40 is usually added in advance during design of the spring sheet 40. In this way, when yield deformation occurs on the spring sheet 40, a sufficient elastic force can still be applied to the power component 30. However, in this design, a force applied to the power component 30 by the spring sheet 40 free of yield deformation is excessively large, and consequently damage to the power component 30 is likely to be caused. In this embodiment, because the amount of deformation of the spring sheet 40 in the mounting process can be controlled in a range in which no yield deformation occurs, an elastic margin reduced due to yield deformation of the spring sheet 40 does not need to be added in advance during design of the spring sheet 40, thereby avoiding damage to the power component 30 due to excessively high pressure of the spring sheet 40 on the power component 30. In addition, the additional elastic margin does not need to be considered during the design of the spring sheet 40, so that design difficulty is reduced, and costs are also correspondingly reduced.

In some implementations, the outer side face 51 includes a first edge 511 connected to the first end face 52 and a second edge 512 connected to the second end face 53. In the first direction Z, the second end face 53 is located between the first end face 52 and the main body part 31, and an end that is of the outer side face 51 and at which the second edge 512 is disposed extends to an end that is of the main body part 31 and that faces the guide support 50. In this implementation, the outer side face 51 may guide the spring sheet 40 to move from the first edge 511 of the outer side face 51 to the second edge 512 of the outer side face 51 and open. It can be learned that the amount of elastic deformation of the spring sheet 40 gradually increases in a moving process. In addition, because the end that is of the outer side face 51 and at which the second edge 512 is disposed extends to the end that is of the main body part 31 and that faces the guide support 50, the spring sheet 40 may be further moved from the second edge 512 of the outer side face 51 to the main body part 31. Specifically, the pressing part 401 is moved to the second surface 312 of the main body part 31 to press the main body part 31 against the heat dissipation structure 20. In addition, in the entire process of mounting the spring sheet 40, due to guidance of the outer side face 51, convenience of mounting the spring sheet 40 can be improved, and yield deformation of the spring sheet 40 may be prevented.

In some implementations, a power component 30 is disposed on each of the first attachment face 211 and the second attachment face 212 that opposite to each other of the liquid cooling pipe. There are two outer side faces 51 of the guide support 50: a first outer side face 54 and a second outer side face 55. Both the first end face 52 and the second end face 53 are located between the first outer side face 54 and the second outer side face 55 in the second direction X, and a width of the first end face 52 in the second direction X is less than a width of the second end face 53 in the second direction X. In this implementation, the width of the first end face 52 in the second direction X is less than the width of the second end face 53 in the second direction X, and both the first end face 52 and the second end face 53 are located between the first outer side face 54 and the second outer side face 55. Therefore, the first outer side face 54, the second outer side face 55, the first end face 52, and the second end face 53 integrally form a structure that approximates an isosceles trapezoid. Therefore, a shorter distance to the main body part 31 indicates a longer distance between the first outer side face 54 and the second outer side face 55 in the second direction X. Therefore, in this implementation, according to a characteristic that in the first direction Z, the distance between the first outer side face 54 and the second outer side face 55 in the second direction X gradually changes, the first outer side face 54 and the second outer side face 55 can properly and precisely guide the spring sheet 40 to move and open, and a value of the amount of deformation of the elastically deformed spring sheet 40 can be controlled in a proper range, to avoid yield deformation of the spring sheet 40 due to a large amount of deformation of the spring sheet 40 which reduces the elastic force of the spring sheet 40.

In some implementations, the spring sheet 40 includes a first spring arm 41, a second spring arm 42, and a connection arm 43 connected between the first spring arm 41 and the second spring arm 42. The first spring arm 41 and the second spring arm 42 are symmetrically disposed relative to the connection arm 43. An end that is of the first spring arm 41 and that is away from the connection arm 43 is a pressing part 401, and an end that is of the second spring arm 42 and that is away from the connection arm 43 is a pressing part 401. In this implementation, the pressing part 401 of the first spring arm 41 presses against a main body part 31 of one power component 30, and the pressing part 401 of the second spring arm 42 presses against a main body part 31 of another power component 30. By using the spring sheet 40 in this implementation, the two power components 30 located on two sides of the liquid cooling pipe can be pressed simultaneously, to effectively reduce a quantity of spring sheets 40. It may be understood that, in this implementation, space between the first spring arm 41 and the second spring arm 42 may be opened, and a larger opening size indicates a larger amount of elastic deformation of the first spring arm 41 and the second spring arm 42 and a larger elastic force. After the space between the first spring arm 41 and the second spring arm 42 of the spring sheet 40 is opened, the power component 30 may be pressed by the first spring arm 41 and the second spring arm 42 for fastening. The guide support 50 is provided with the first outer side face 54 and the second outer side face 55, and a shorter distance to the main body part 31 indicates a longer distance between the first outer side face 54 and the second outer side face 55 in the second direction X. Therefore, a size of an opening between the first spring arm 41 and the second spring arm 42 of the spring sheet 40 can gradually increase through guidance of the first outer side face 54 and the second outer side face 55. Finally, the first outer side face 54 and the second outer side face 55 are used to move the pressing part 401 of the first spring arm 41 to a second surface 312 of one power component 30, and move the pressing part 401 of the second spring arm 42 to a second surface 312 of another power component 30. In addition, in the entire process of mounting the spring sheet 40, the spring sheet 40 can be precisely mounted due to guidance of the first outer side face 54 and the second outer side face 55, to prevent yield deformation of the spring sheet 40 in the mounting process, and further prevent damage to the power component 30 due to impact of a large force on the power component 30 caused by sudden and dramatic deformation of the spring sheet 40.

In some implementations, the first end face 52 presses against the connection arm 43, and the second surface 312 presses against the pressing part 401. In this implementation, the spring sheet 40 is in a state existing when mounting is completed. In this case, the connection arm 43 of the spring sheet 40 presses against on the first end face 52. The first end face 52 may further play a limiting role, so that when the spring sheet 40 is mounted in place, the first end face 52 may prevent the spring sheet 40 from continuing to move. Therefore, in a process of quickly mounting the spring sheet 40, the spring sheet 40 can be quickly and precisely mounted through a fit between the first end face 52 and the connection arm 43.

In some implementations, when mounting of the spring sheet 40 is completed, the second edge 512 of the first side face presses against the first spring arm 41, and the second edge 512 of the second side face presses against the second spring arm 42. In addition, when mounting of the spring sheet 40 is completed, the second surface 312 presses against the pressing part 401 of the spring sheet 40. In other words, in a state in which mounting of the spring sheet 40 is completed, the first spring arm 41 is supported by the second edge 512 of the first outer side face 54 and a second surface 312 of one power component 30. Similarly, the second spring arm 42 is supported by the second edge 512 of the second outer side face 55 and a second surface 312 of another power component 30. In this design, when the pressing part 401 of the first spring arm 41 is in contact with one second surface 312 of the power component 30, a large impact force on the power component 30 can be avoided. Similarly, when the pressing part 401 of the second spring arm 42 is in contact with the other second surface 312 of the power component 30, a large impact force on the power component 30 can also be avoided. Therefore, in the process of mounting the spring sheet 40, damage to the power components 30 can be effectively avoided.

In some implementations, when the spring sheet 40 is in a natural state, an opening is formed between the pressing part 401 of the first spring arm 41 and the pressing part 401 of the second spring arm 42. In this implementation, when the spring sheet 40 is in the natural state, the opening is formed between the pressing part 401 of the first spring arm 41 and the pressing part 401 of the second spring arm 42. Therefore, the first spring arm 41 and the second spring arm 42 can be conveniently pressed on the first outer side face 54 and the second outer side face 55 through the opening. This can effectively facilitate mounting of the spring sheet 40.

In some implementations, a size of the opening between the pressing part 401 of the first spring arm 41 and the pressing part 401 of the second spring arm 42 in the second direction X is greater than a size of the first end face 52 in the second direction X, and is less than a size of the second end face 53 in the second direction X. Therefore, the first outer side face 54 and the second outer side face 55 of the guide support 50 can be conveniently inserted between the pressing part 401 of the first spring arm 41 and the pressing part 401 of the second spring arm 42, to better facilitate mounting.

In some implementations, the pressing part 401 of the first spring arm 41 presses against a middle part of the second surface 312 of one power component 30. The pressing part 401 of the second spring arm 42 presses against a middle part of the other second surface 312 of the power component 30. In this design, the power component 30 can be more evenly subject to a force, and the first surface 311 of the power component 30 is more evenly subject to pressure when the first surface 311 of the power component 30 is attached to the liquid cooling pipe, to improve a heat dissipation effect of the liquid cooling pipe on the power component 30.

To smoothly move the pressing part 401 of the spring sheet 40 from the outer side face 51 to the second surface 312 of the main body part 31, in some implementations, in the second direction X, the second surface 312 is located between the first surface 311 and the second edge 512. In this implementation, in the second direction X, the second surface 312 is located between the first surface 311 and the second edge 512. Therefore, in a process of moving from the outer side face 51 to the second surface 312, the pressing part 401 is not interfered by an end face of the end that is of the main body part 31 and that faces the guide support 50, so that the pressing part 401 of the spring sheet 40 can move naturally and smoothly from the outer side face 51 to the second surface 312 of the main body part 31. In addition, damage to the power component 30 due to large impact on the power component 30 is avoided.

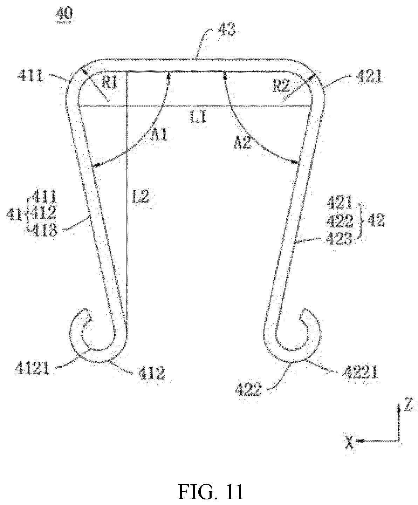

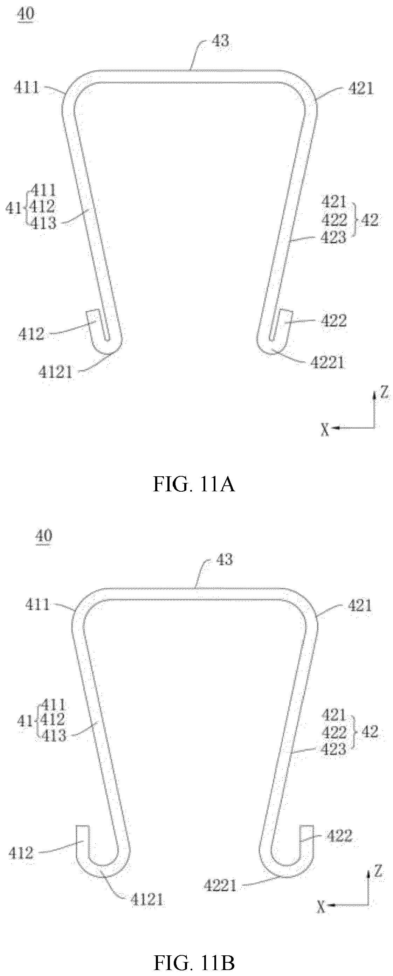

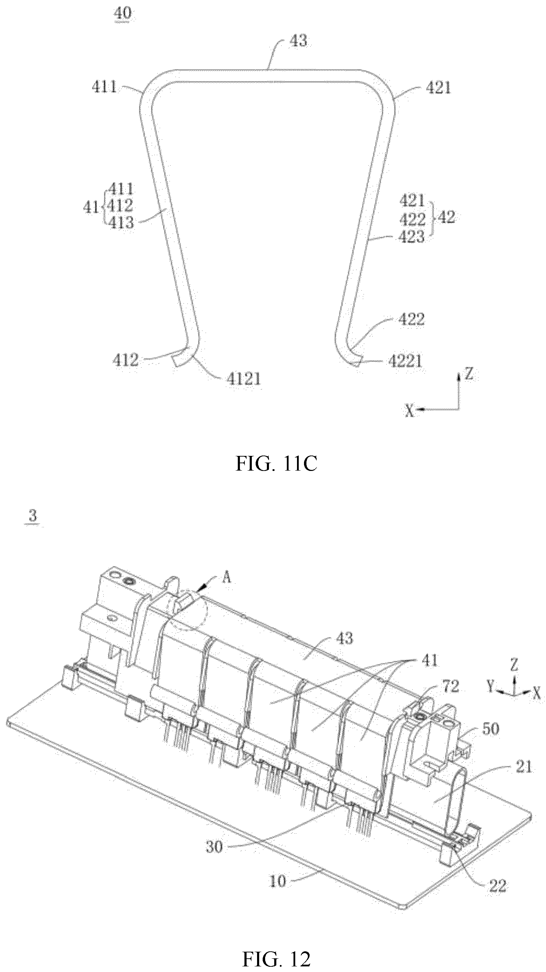

In some implementations, a distance between the second edge 512 and the second surface 312 in the second direction X is L, and L is 0 mm to 1 mm. L is in this range. This can avoid yield deformation due to excessively large elastic deformation of the spring sheet 40 caused by the outer side face 51, and can make the pressing part 401 of the spring sheet 40 move naturally and smoothly from the outer side face 51 to the second surface 312 of the main body part 31, thereby improving mounting efficiency of the spring sheet 40. It may be understood that, when L is 0 mm, it means that the second edge 512 is just located in a plane in which the second surface 312 is located. In some embodiments, the pressing part 401 of the spring sheet 40 is of a structure that approximates a circular arc segment (refer to a first circular arc segment 4121 or a second circular arc segment 4221 in FIG. 11). Therefore, when L is 0 mm, even if there is a manufacturing tolerance, because the pressing part 401 of the spring sheet 40 is of the circular arc segment structure, the pressing part 401 can smoothly move from the outer side face 51 to the second surface 312 of the main body part 31, to ensure smooth mounting of the spring sheet 40.

Refer to FIG. 2 and FIG. 6. In some implementations, in the length direction of the liquid cooling pipe, a plurality of power components 30 are spaced apart on the liquid cooling pipe, and the plurality of power components 30 press against the liquid cooling pipe by using a plurality of spring sheets 40 in a one-to-one correspondence with the power components 30.

In some implementations, the guide support 50 includes a top plate 56 that is in a long bar shape and a first side plate 57 and a second side plate 58 that are in long bar shapes. Length directions of the top plate 56, the first side plate 57, and the second side plate 58 are the same. The first side plate 57 and the second side plate 58 are symmetrically disposed on two sides of the top plate 56 with respect to the top plate 56. The top plate 56, the first side plate 57, and the second side plate 58 are approximately an isosceles trapezoid. The first end face 52 is an outer surface of the top plate 56. The first outer side face 54 is an outer surface of the first side plate 57. The second outer side face 55 is an outer surface of the second side plate 58.

To further improve accuracy and speed of mounting the spring sheet 40, in some implementations, in the length direction Y of the guide support 50, a plurality of partition plates 501 are spaced apart on the outer side face 51 of the guide support 50, and one spring sheet 40 is disposed between two adjacent partition plates 501. In this implementation, the partition plates 501 are disposed to limit a spring sheet 40 between two adjacent partition plates 501. When a spring sheet 40 is mounted, the spring sheet 40 can be precisely and quickly guided to a required mounting position by using two adjacent partition plates 501 and the outer side face 51. In addition, because the partition plate 501 separates two adjacent spring sheets 40, a creepage distance between the two adjacent spring sheets 40 can be effectively increased, to meet a production compliance standard.

In some implementations, a plurality of partition plates 501 are spaced apart on the first outer side face 54.

In some implementations, a plurality of partition plates 501 are spaced apart on the first outer side face 54, and a plurality of partition plates 501 are spaced apart on the second outer side face 55.

In some implementations, in the length direction Y of the guide support 50, a plurality of inner stiffener structures 502 are spaced apart on an inner surface of the guide support 50, and the plurality of inner stiffener structures 502 can effectively improve overall strength of the guide support 50.

In some implementations, one end of the insulating heat-conducting plate 60 in the first direction Z is disposed on the pipe support 22, and the other end of the insulating heat-conducting plate 60 in the first direction Z extends to the inner stiffener structure 502 in the accommodation region 504. Through limiting of the inner stiffener structure 502 and the pipe support 22 in the first direction Z, the insulating heat-conducting plate 60 can be prevented from rotating relative to the liquid cooling pipe during mounting of the spring sheet 40, to ensure smooth mounting of the spring sheet 40. In this case, as shown in FIG. 6A, it can be learned that the other end of the insulating heat-conducting plate 60 in the first direction Z extends to the inner stiffener structure 502 in the accommodation region 504, so that a creepage distance H between the connection arm 43 of the spring sheet 40 and the power component 30 can be effectively increased, to prevent electric ignition, thereby improving use safety.

Refer to FIG. 2 and FIG. 6. In some implementations, the mounting structure 3 of the power component further includes a pressing rod 70, and the pressing rod 70 is configured to fasten the mounted spring sheet 40 to the guide support 50, to prevent the spring sheet 40 from loosening.

In some implementations, the pressing rod 70 is in a long bar shape. The pressing rod 70 presses against the plurality of spring sheets 40, to simultaneously fasten the plurality of spring sheets 40 to the guide support 50. It may be understood that, in some other implementations, the pressing rod 70 may alternatively be used to fasten only one spring sheet 40.

In some implementations, fixing holes 701 are disposed at two ends of the pressing rod 70, and the pressing rod 70 is fastened to two ends of the guide support 50 in the length direction Y through the fixing holes 701 at the two ends of the pressing rod 70.

In some implementations, the pressing rod 70 is fastened to the guide support 50, and the connection arms 43 of the plurality of spring sheets 40 are located between the pressing rod 70 and the first end face 52. In this implementation, the pressing rod 70 is disposed to fasten the plurality of spring sheets 40 to the guide support 50, and it is not necessary to fasten each spring sheet 40 by using a bolt or the like. This simplifies an assembly process.

In some implementations, the partition plate 501 disposed on the first outer side face 54 and the partition plate 501 disposed on the second outer side face 55 are spaced in the second direction X, both protrude from the first end face 52, and form an assembly groove for assembling the pressing rod 70. The pressing rod 70 is disposed in the assembly groove, to improve stability of a connection between the pressing rod 70 and the guide support 50.

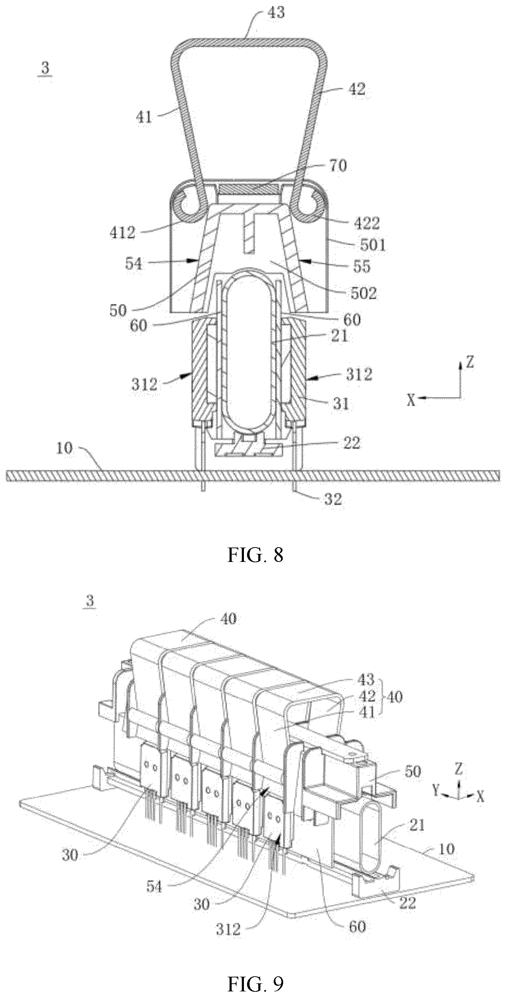

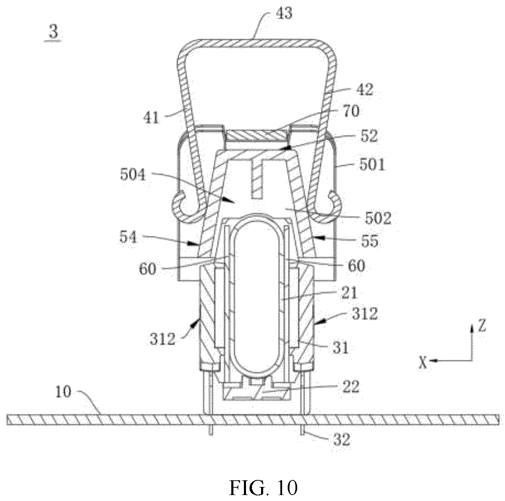

FIG. 7 is a diagram of a structure obtained when a spring sheet 40 of the mounting structure 3 of the power component in the embodiment in FIG. 2 starts to be mounted. FIG. 8 is a sectional view of the mounting structure 3 of the power component in FIG. 7. FIG. 9 is a diagram of a structure of the mounting structure 3 of the power component in the embodiment in FIG. 2 in a mounting process. FIG. 10 is a sectional view of the mounting structure 3 of the power component in FIG. 9.

Refer to FIG. 2 and FIG. 6 to FIG. 10. The following focuses on a mounting principle of the spring sheet 40.

To reduce stress of the pin 32 of the power component 30, the power component 30 is pressed and then welded (first, the spring sheet 40 is mounted at a specified position to form pressure on the power component 30, and then the pin 32 of the power component 30 is welded). Before the spring sheet 40 is mounted, the power component 30 and the insulating heat-conducting plate 60 are bonded together by using a thermal adhesive, and then the insulating heat-conducting plate may be bonded to the first attachment face 211 of the liquid cooling pipe by using thermally conductive silicone grease. The guide support 50 is placed above the liquid cooling pipe and fastened to the pipe support 22, a PCB, or the like.

In this case, parts and components except the spring sheet 40 and the pressing rod 70 are mounted in place. In this case, the inner stiffener structure 502 of the guide support 50 may limit an assembly of the insulating heat-conducting plate 60 and the power component 30 to tilt outward. In this case, the pressing part 401 of the spring sheet 40 is placed above the guide support 50, and is clamped on the top of the guide support 50. After the foregoing operations are completed, a plurality of spring sheets 40 may be placed on the guide support 50 in the same way, to implement an operation of mounting the plurality of spring sheets 40 at a time.

First, refer to FIG. 7 and FIG. 8. In this case, the opening between the pressing part 401 of the first spring arm 41 and the pressing part 401 of the second spring arm 42 is inserted on two side faces (the first outer side face 54 and the second outer side face 55) of the guide support 50. In other words, the pressing part 401 of the first spring arm 41 presses against the first outer side face 54, and the pressing part 401 of the second spring arm 42 presses against the second outer side face 55. In this case, the first spring arm 41 and the second spring arm 42 are not elastically deformed, or are only slightly elastically deformed. Then, pressure is applied to the connection arm 43 in the first direction Z from the first end face 52 to the second end face 53 by using an external force (for example, a machine or a human force). Under the pressure, the opening between the pressing part 401 of the first spring arm 41 and the pressing part 401 of the second spring arm 42 gradually increases. In addition, the pressing part 401 of the first spring arm 41 gradually moves toward the main body part 31 along the first outer side face 54, the pressing part 401 of the second spring arm 42 gradually moves toward the main body part 31 along the second outer side face 55, and a position of the spring sheet 40 relative to the guide support 50 gradually moves from a position shown in FIG. 7 to a position in FIG. 9 and FIG. 10.

Refer to FIG. 9 and FIG. 10. In this case, the pressing part 401 of the first spring arm 41 presses against a middle part of the first outer side face 54, and the pressing part 401 of the second spring arm 42 presses against a middle part of the second outer side face 55. The first spring arm 41 and the second spring arm 42 are elastically deformed. In this case, there is still a specific distance between the connection arm 43 and the first end face 52, and pressure may continue to be applied to the connection arm 43 in the first direction Z from the first end face 52 to the second end face 53 by using the external force (for example, the machine or the human force). Under the pressure, the opening between the pressing part 401 of the first spring arm 41 and the pressing part 401 of the second spring arm 42 continues to increase. When the pressing part 401 of the first spring arm 41 reaches the second edge 512 of the first outer side face 54, and the pressing part 401 of the second spring arm 42 reaches the second edge 512 of the second outer side face 55, the opening between the pressing part 401 of the first spring arm 41 and the pressing part 401 of the second spring arm 42 is maximum. Pressure continues to be applied to the connection arm 43 in the first direction Z from the first end face 52 to the second end face 53, so that the pressing part 401 of the first spring arm 41 is transferred from the first outer side face 54 to the second surface 312 of the main body part 31, the pressing part 401 of the second spring arm 42 is transferred from the second outer side face 55 to the second surface 312 of another main body part 31, and the connection arm 43 presses against the first end face 52 for limiting, to prevent the connection arm 43 continues to move forward. In this case, the position of the spring sheet 40 relative to the guide support 50 is moved from the position in FIG. 9 and FIG. 10 to the position in FIG. 2 and FIG. 6.

In a process of mounting the spring sheet 40, the first outer side face 54 may guide the pressing part 401 of the first spring arm 41 to move to the second surface 312 of the main body part 31. The second outer side face 55 may guide the pressing part 401 of the second spring arm 42 to move to the second surface 312 of another main body part 31. The two main body parts 31 are located on two sides of the liquid cooling pipe in the second direction X. In the foregoing process, an amount of elastic deformation of the spring sheet 40 basically changes in a process of gradually increasing and then gradually decreasing. Specifically, in a process in which the spring sheet 40 moves from the first end face 52 to the second end face 53, that is, in a process in which the pressing part 401 of the first spring arm 41 moves from the first edge 511 of the first outer side face 54 to the second edge 512 of the first outer side face 54, and in a process in which the pressing part 401 of the second spring arm 42 moves from the first edge 511 of the second outer side face 55 to the second edge 512 of the second outer side face 55, the first outer side face 54 always directly presses against the pressing part 401 of the first spring arm 41 and is subject to a force, and the second outer side face 55 is always directly presses against the pressing part 401 of the second spring arm 42 and is subject to a force. Therefore, the first outer side face 54 and the second outer side face 55 can guide the spring sheet 40 for smooth increase in elastic deformation. When the pressing part 401 of the first spring arm 41 and the pressing part 401 of the second spring arm 42 respectively reach the second edge 512 of the first outer side face 54 and the second edge 512 of the second outer side face 55, an amount of elastic deformation of the spring sheet 40 does not cause yield deformation of the spring sheet 40. Therefore, in the entire process, the spring sheet 40 does not undergo yield deformation. Therefore, the spring sheet 40 can be effectively controlled to avoid yield deformation by disposing the first outer side face 54 and the second outer side face 55. In a process in which the pressing part 401 of the spring sheet 40 moves from the first outer side face 54 and the second outer side face 55 to the second surface 312 of the main body part 31, an amount of elastic deformation of the spring sheet 40 basically changes in a brief process of gradually decreasing. In this process, the second edge 512 of the first outer side face 54 always presses against the first spring arm 41, and the second edge 512 of the second outer side face 55 always presses against the second spring arm 42. Therefore, it can be ensured that when the pressing part 401 of the spring sheet 40 moves from the first outer side face 54 and the second outer side face 55 to the second surface 312 of the main body part 31, transient large elastic deformation is avoided, and the main body part 31 is not damaged by a large transient impact force applied by the pressing part 401 of the spring sheet 40 on the main body part 31.

After all the spring sheets 40 are mounted, the plurality of spring sheets 40 are fastened to the guide support 50 by using the pressing rod 70, so that all the plurality of spring sheets 40 can stably presses against the plurality of power components 30.

FIG. 11 is a front view of a spring sheet 40 according to an embodiment of this application. The spring sheet 40 in the embodiment in FIG. 11 may be used in the mounting structure 3 of the power component in the foregoing embodiments.

Refer to FIG. 6 and FIG. 11. In some embodiments, the first spring arm 41 includes a first arc corner part 411, a first pressing part 412, and a first connection part 413 connected between the first arc corner part 411 and the first pressing part 412. The first arc corner part 411 is connected between the first connection part 413 and the connection arm 43. It may be understood that the first pressing part 412 in this embodiment is the pressing part 401 of the first spring arm 41 described above.

The second spring arm 42 and the first spring arm 41 are symmetrically disposed relative to the connection arm 43.

In other words, the second spring arm 42 also includes a second arc corner part 421, a second pressing part 422, and a second connection part 423 connected between the second arc corner part 421 and the second pressing part 422. It may be understood that the second pressing part 422 in this embodiment is the pressing part 401 of the second spring arm 42 described above.

In addition, because the second spring arm 42 and the first spring arm 41 are symmetrically disposed relative to the connection arm 43, a main deformation part and a maximum-stress part of the spring sheet 40 may be a central part of the connection arm 43 on the top of the spring sheet 40. This effectively avoids yield deformation of the first spring arm 41 and the second spring arm 42, so that a structure of the spring sheet 40 more stable.

In some implementations, the first arc corner part 411 is in a circular arc shape, and a radius of the first arc corner part 411 is R1. The second arc corner part 421 is in a circular arc shape, and a radius of the second arc corner part 421 is R2. In this implementation, a joint between the first spring arm 41 and the connection arm 43 is the first arc corner part 411 in the circular arc shape, and a joint between the second spring arm 42 and the connection arm 43 is the second arc corner part 421 in the circular arc shape. This can effectively improve an elastic deformation resistance capability of a part between the first spring arm 41 and the connection arm 43, and effectively improve an elastic deformation resistance capability between the second spring arm 42 and the connection arm 43, thereby increasing overall yield strength of the spring sheet 40.

In some implementations, an included angle A1 is formed between the connection arm 43 and the first connection part 413, and 45 degrees<A1<90 degrees. Similarly, an included angle A2 is formed between the connection arm 43 and the second connection part 423, and 45 degrees<A2<90 degrees. In this implementation, the entire spring sheet 40 is approximately an inverted trapezoid, so that the pressing part 401 at a lower end of the spring sheet 40 presses against the power component 30 more conveniently. This can also ensure a sufficient length of the connection arm 43 in the second direction X, to reduce overall stress rigidity and elastic rigidity of the spring sheet 40, so that the spring sheet 40 can obtain a larger amount of deformation in a yield range, thereby reducing impact of a tolerance and an error during production and manufacturing of the spring sheet 40.

Correspondingly, in some implementations, an included angle B1 is formed between the first side plate 57 and the top plate 56 (as shown in FIG. 5) that are of the guide support 50 fitting the spring sheet 40, and an angle range of B1 satisfies 92 degrees≤B1≤135 degrees. An included angle B2 is formed between the second side plate 58 and the top plate 56 (as shown in FIG. 5), and an angle range of B2 satisfies 92 degrees≤B2≤135 degrees. This can effectively fit mounting of the spring sheet 40, provide a press-type mounting method for the spring sheet 40, and effectively resolve a problem of mounting difficulty of the spring sheet 40 and a possible yield risk in the mounting process. In addition, the guide support 50 characterized by a trapezoid that is narrow at the top and wide at the bottom fits the spring sheet 40 characterized by a trapezoid that is wide at the top and narrow at the bottom, which can also effectively increase the creepage distance between the connection arm 43 of the spring sheet 40 and the power component 30 (refer to FIG. 6A). This can also effectively ensure that a side arm of the spring sheet 40 is not in contact with the guide support 50. In this way, a maximum-deformation part of the spring sheet 40 after mounting is completed is the central part of the connection arm 43. In this implementation, the connection arm 43 of the spring sheet 40 is designed to be long in the second direction X, to effectively improve yield strength of the spring sheet 40. It should be noted that the yield strength of the spring sheet 40 is limit strength of the spring sheet 40 when the spring sheet 40 undergoes yield deformation.

In some implementations, a distance, in the second direction X, between an end part that is of the first connection part 413 and that is connected to the first arc corner part 411 and an end part that is of the second connection part 423 and that is connected to the second arc corner part 421 is L1, and a range of L1 is 16 mm≤L1≤40 mm. In this range, it can be ensured that the length of the connection arm 43 in the second direction X is long enough, so that the maximum-deformation part of the spring sheet 40 after mounting is completed is the central part of the connection arm 43. This can effectively improve the yield strength of the spring sheet 40.

In some implementations, a length of the first connection part 413 in the first direction Z is L2, and a range of L2 satisfies 20 mm≤L2≤40 mm, to ensure that the spring sheet 40 provides sufficient deformation space, and effectively avoid bending instability of the connection arm 43 of the spring sheet 40.

In some implementations, a range of the radius R1 of the first arc corner part 411 satisfies: 3 mm≤R1≤8 mm, and a range of the radius R2 of the second arc corner part 421 satisfies: 3 mm≤R2≤8 mm. This can ensure that high stress concentration is avoided during machining of the spring sheet 40, and can ensure that a size of the connection arm of the spring sheet 40 is not affected due to excessive large ranges of R1 and R2.

In some embodiments, the first pressing part 412 includes a first circular arc segment 4121. One end of the first circular arc segment 4121 is connected to an end part of the first connection part 413, and is tangent to the first connection part 413. The first circular arc segment 4121 is located on a side that is of the first connection part 413 and that is away from the power component 30. In this embodiment, because one end of the first circular arc segment 4121 is connected to the end part of the first connection part 413, and is tangent to the end part of the first connection part 413, after the spring sheet 40 is mounted, a part that is of the spring sheet 40 and that is in contact with the pressed power component 30 may be a part in the first circular arc segment 4121, to ensure that the part that is of the spring sheet 40 and that is in contact with the power component 30 is on an arc tangent line on which pressure of the first circular arc segment 4121 acts. In addition, because one end of the first circular arc segment 4121 is connected to the end part of the first connection part 413, and is tangent to the end part of the first connection part 413, even if a position shift occurs after the spring sheet 40 is mounted, the acting force of the spring sheet 40 on the power component 30 remains in a vertical direction of the pressed power component 30, namely, a direction perpendicular to the second surface 312. In this way, positive pressure perpendicular to the pressed power component 30 can still be provided, to ensure consistency of pressure directions. In addition, because one end of the first circular arc segment 4121 is connected to the end part of the first connection part 413, and is tangent to the end part of the first connection part 413, it can be further ensured that friction between the spring sheet 40 and the outer side face 51 of the guide support 50 in the mounting process can be reduced when there is a deviation between the spring sheet 40 and the pressed power component 30, thereby ensuring that the first circular arc segment 4121 can be smoothly mounted through sliding. In addition, because one end of the first circular arc segment 4121 is connected to the end part of the first connection part 413, and is tangent to the end part of the first connection part 413. When moving to a boundary region between the guide support 50 and the power component 30, the spring sheet 40 smoothly slides to the second surface 312 of the power component 30 through a large circular arc surface of the spring sheet 40, thereby avoiding strong vibration. Then, the spring sheet 40 continues to slide under pressure, to complete mounting. In the entire mounting process, excessive deformation of the spring sheet 40 can be avoided.

It may be understood that a structure of the first circular arc segment 4121 provided on the spring sheet 40 is not limited to the foregoing structure form, provided that a point that can be provided for clamping the power component 30 is located in the first circular arc segment 4121. For example, the first circular arc segment 4121 may alternatively be of a structure shown in FIG. 11A, FIG. 11B, or FIG. 11C. For example, the first pressing part 412 may further include a bent segment connected to the other end of the first circular arc segment 4121.

Similarly, in some embodiments, the second pressing part 422 includes a second circular arc segment 4221. One end of the second circular arc segment 4221 is connected to an end part of the second connection part 423, and is tangent to the end part of the second connection part 423. The second circular arc segment 4221 is located on a side that is of the second connection part 423 and that is away from the power component 30. It may be understood that a structure of the second circular arc segment 4221 provided on the spring sheet 40 is not limited to the foregoing structure form, provided that a point that can be provided for clamping the power component 30 is located in the second circular arc segment 4221. For example, the second circular arc segment 4221 may alternatively be of a structure shown in FIG. 11A, FIG. 11B, and FIG. 11C. For example, the second pressing part 422 may further include a bent segment connected to the other end of the second circular arc segment 4221. The second circular arc segment 4221 is disposed. The second circular arc segment 4221 has a same structure as that of the first circular arc segment 4121, and achieves a same effect as that achieved by the first circular arc segment 4121. Specifically, refer to the first circular arc segment 4121. Details are not described herein again.

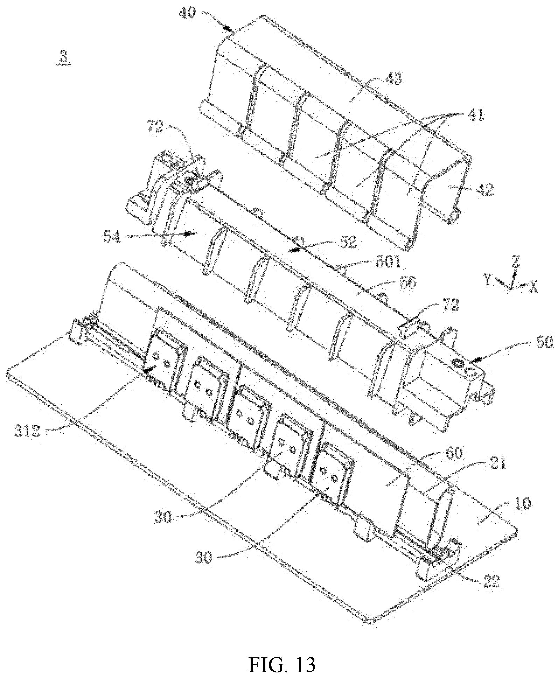

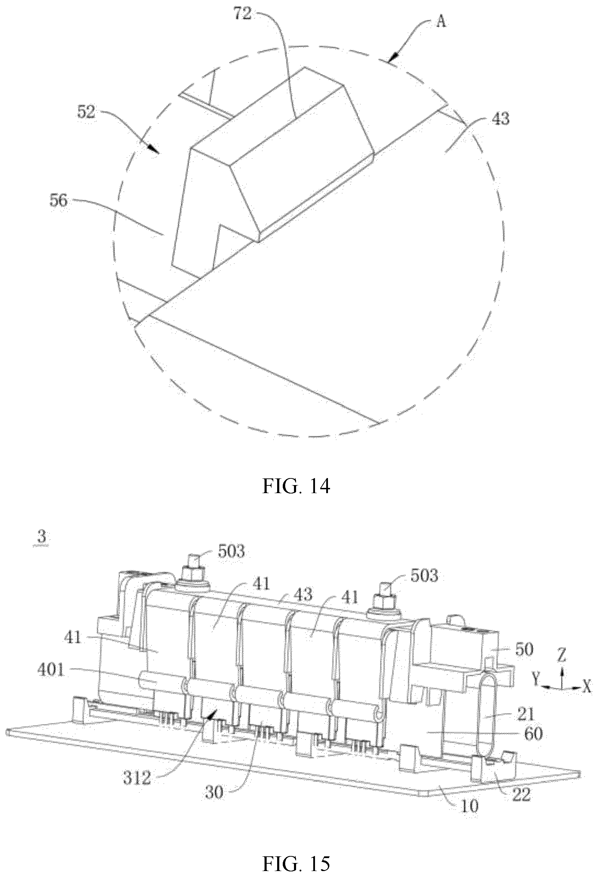

FIG. 12 is a diagram of a structure of another mounting structure 3 of a power component according to an embodiment of this application. FIG. 13 is an exploded view of the mounting structure 3 of the power component in FIG. 12. FIG. 14 is a partially enlarged diagram of A in FIG. 12. The mounting structure 3 of the power component in the embodiment in FIG. 12 is an extended embodiment based on the mounting structure 3 of the power component in the embodiment in FIG. 2. The following focuses on characteristics of the mounting structure 3 of the power component in the embodiment in FIG. 12 that are different from those of the mounting structure 3 of the power component in the embodiment in FIG. 2. For parts that are not described emphatically or that are not described in the embodiment in FIG. 12, refer to the embodiments in FIG. 2 to FIG. 11. Details are not described again in the following.

Refer to FIG. 12 to FIG. 14. In some embodiments, the spring sheet 40 includes a connection arm 43 and a plurality of first spring arms 41 and second spring arms 42 that are connected to the connection arm 43. The connection arm 43 is of a long bar structure whose length direction is the same as a length direction of the top plate 56 of the guide support 50. The connection arm 43 includes two opposite long edges in a second direction X, namely, two long edges of the connection arm 43 in the length direction. A plurality of first spring arms 41 are spaced apart on and connected to a long edge of the connection arm 43 in the length direction of the connection arm 43, and a plurality of second spring arms 42 are spaced apart on and connected to another long edge of the connection arm 43 in the length direction of the connection arm 43. Each first spring arm 41 and each second spring arm 42 of the spring sheet 40 in this embodiment can press against one power component 30, so that the spring sheets 40 in this embodiment can simultaneously press against a plurality of power components 30, and mounting of the spring sheets is faster and more convenient than that in the foregoing embodiments. In addition, the plurality of first spring arms 41 and the plurality of second spring arms 42 are simultaneously connected to the connection arm 43. Even if a deviation occurs during mounting of different first spring arms 41 and second spring arms 42 or a tolerance exists during production of different first spring arms 41 and second spring arms 42, because the plurality of first spring arms 41 and the plurality of second spring arms 42 are a whole and can interact with each other, impact caused by the deviation during mounting or the tolerance during production can be effectively eliminated.

In some implementations, each first spring arm 41 is symmetrically disposed with a second spring arm 42 in the second direction X. One first spring arm 41 and one second spring arm 42 are set as a pair. Because each first spring arm 41 is symmetrically disposed with one second spring arm 42 in the second direction X, an elastic force error between each pair of first spring arm 41 and second spring arm 42 can be effectively reduced.

Certainly, in some other implementations, the first spring arm 41 and the second spring arm 42 may alternatively not be symmetrically disposed. For example, the first spring arm 41 and the second spring arm 42 may alternatively be staggered in a length direction of the connection arm 43.

It may be understood that, for structures of the first spring arm 41 and the second spring arm 42, limitations on sizes between the first spring arm 41 and the connection arm 43 and between the second spring arm 42 and the connection arm 43, and the like, refer to the spring sheet 40 in the embodiment in FIG. 11. Details are not described herein again.

In some implementations, a fastener 72 is disposed at each end of the guide support 50 in a length direction. After the spring sheet 40 is mounted, two ends of the connection arm 43 in the length direction are respectively engaged with and connected to the two fasteners 72, so that the spring sheet 40 is fastened to the guide support 50. Compared with that in the embodiment in FIG. 2, in the mounting structure 3 of the power component in this embodiment, the pressing rod 70 is removed, and a position of the spring sheet 40 is limited by the fasteners 72. The mounting structure 3 of the power component in this embodiment has a simple structure. When the spring sheet 40 is mounted, the spring sheet 40 can be directly pressed to a specified position to be engaged and fastened, facilitating mounting.

It may be understood that, in some other implementations, the fastener 72 may alternatively be a fastening manner like a bolt or a screw. Alternatively, the spring sheet 40 may be fastened to the guide support 50 by using an elastic force of the spring sheet 40.

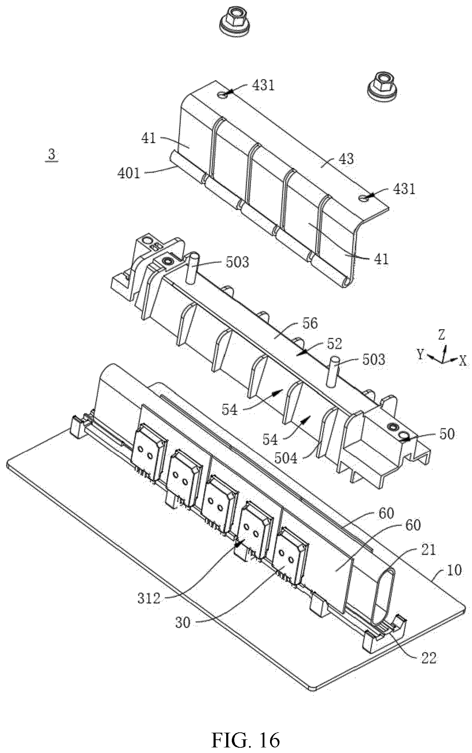

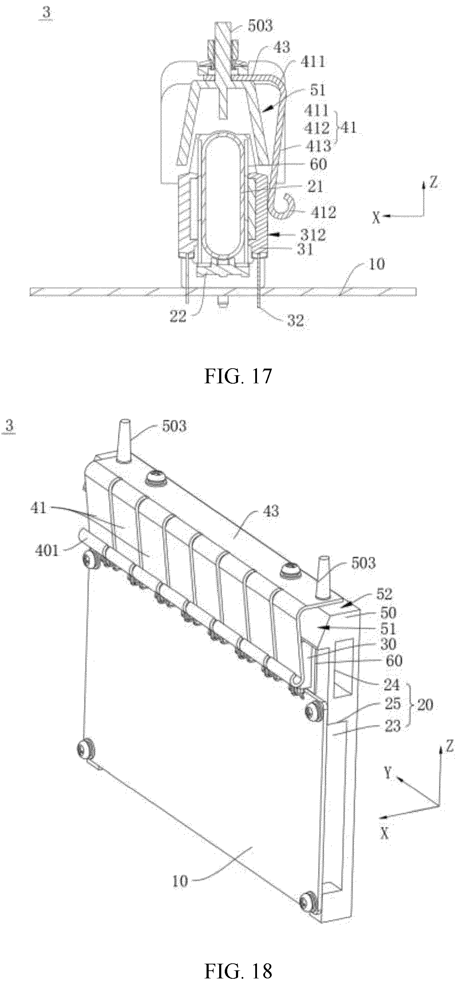

FIG. 15 is a diagram of a structure of still another mounting structure 3 of a power component according to an embodiment of this application. FIG. 16 is a schematic exploded view of the mounting structure 3 of the power component in FIG. 15. FIG. 17 is a sectional view of the mounting structure 3 of the power component in FIG. 15. The mounting structure 3 of the power component in the embodiment in FIG. 15 is an extended embodiment based on the mounting structure 3 of the power component in the embodiment in FIG. 2. The following focuses on characteristics of the mounting structure 3 of the power component in the embodiment in FIG. 15 that are different from those of the mounting structure 3 of the power component in the embodiment in FIG. 2. For parts that are not described emphatically or that are not described in the embodiment in FIG. 15, refer to the embodiments in FIG. 2 to FIG. 11. Details are not described again in the following.

Refer to FIG. 15 to FIG. 17. In some embodiments, the spring sheet 40 includes a connection arm 43 and a plurality of first spring arms 41 connected to the connection arm 43. The connection arm 43 is of a long bar structure whose length direction is the same as a length direction of the top plate 56 of the guide support 50. In a length direction of the connection arm 43, the plurality of first spring arms 41 are spaced apart on and connected to a long edge in the length direction of the connection arm 43. A guide hole 431 is provided on the connection arm 43, and a guide post 503 is disposed on the top plate 56 of the guide support 50. The guide hole 431 is sleeved on the guide post 503. In this embodiment, under an action of limiting of the guide post 503, when the guide hole 431 is sleeved on the guide post 503 and the connection arm 43 is pressed down, the first spring arm 41 is elastically deformed as the outer side face 51 of the guide support 50 gradually extends, so that a sufficient elastic force can be generated to press against the power component 30, to fasten the power component 30.

In some implementations, the guide post 503 is provided with an external thread. After the spring sheet 40 is mounted, the spring sheet 40 may be fastened to the guide support 50 through a threaded connection between a nut and the guide post 503.

In some implementations, a guide post 503 configured to fit the guide hole 431 is provided on the top plate 56 of the guide support 50. There are a plurality of guide posts 503 and a plurality of guide holes 431. The plurality of guide posts 503 are arranged in a length direction of the top plate 56, and the plurality of guide holes 431 are distributed on the connection arm 43 in a length direction of the connection arm 43. Because the connection arm 43 is long, the plurality of guide holes 431 are provided, and the plurality of guide holes 431 are distributed on the connection arm 43 in the length direction of the connection arm 43, to ensure that all the plurality of first spring arms 41 of the spring arms can obtain a sufficient elastic force to press the power component 30 after mounting is completed.

It may be understood that, when the power component 30 is disposed only on one side of the liquid cooling pipe, the power component 30 can be effectively fastened by the plurality of first spring arms 41. In some other implementations, the spring sheet 40 may further include a plurality of second spring arms 42, and the plurality of second spring arms 42 and the plurality of first spring arms 41 are symmetrically disposed relative to the connection arm 43, to cope with a use scenario in which the power components 30 are disposed on both sides of the liquid cooling pipe.

It may be understood that, for structures of the first spring arm 41 and the second spring arm 42, limitations on sizes between the first spring arm 41 and the connection arm 43 and between the second spring arm 42 and the connection arm 43, and the like in this embodiment, refer to the spring sheet 40 in the embodiment in FIG. 11. Details are not described herein again.

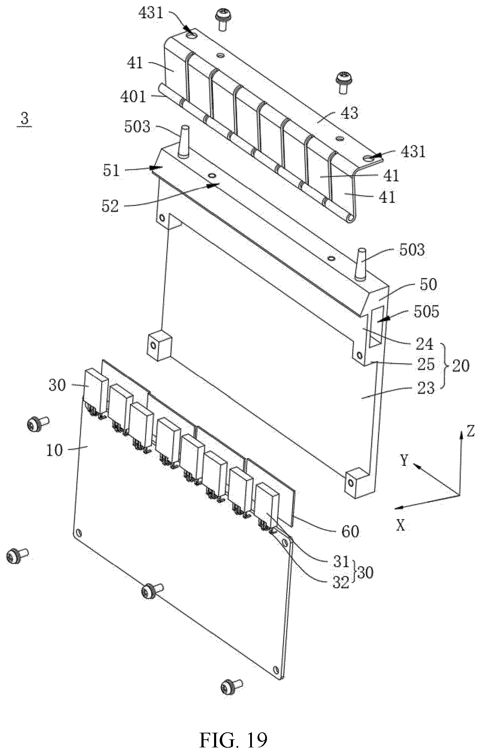

FIG. 18 is a diagram of a structure of still another mounting structure 3 of a power component according to an embodiment of this application. FIG. 19 is a schematic exploded view of the mounting structure 3 of the power component in FIG. 18. The mounting structure 3 of the power component in the embodiment in FIG. 18 is an extended embodiment based on the mounting structure 3 of the power component in the embodiment in FIG. 2. The following focuses on characteristics of the mounting structure 3 of the power component in the embodiment in FIG. 18 that are different from those of the mounting structure 3 of the power component in the embodiment in FIG. 2. For parts that are not described emphatically or that are not described in the embodiment in FIG. 18, refer to the embodiments in FIG. 2 to FIG. 11. Details are not described again in the following.

Refer to FIG. 18 and FIG. 19. In some embodiments, the spring sheet 40 includes a connection arm 43 and a plurality of first spring arms 41 connected to the connection arm 43. The connection arm 43 is of a long bar structure whose length direction is the same as a length direction of the top plate 56 of the guide support 50. In a length direction of the connection arm 43, the plurality of first spring arms 41 are spaced apart on and connected to a long edge in the length direction of the connection arm 43. A guide hole 431 is provided on the connection arm 43, and the guide hole 431 is sleeved on the guide post 503. In this embodiment, under an action of limiting of the guide post 503, when the guide hole 431 is sleeved on the guide post 503 and the connection arm 43 is pressed down, the first spring arm 41 is elastically deformed as the outer side face 51 of the guide support 50 gradually extends, so that a sufficient elastic force can be generated to press against the power component 30, to fasten the power component 30.

In some implementations, the connection arm 43 is provided with a threaded hole, and after mounting of the spring sheet 40 is completed, the connection arm 43 is fastened to the top plate 56 of the guide support 50 by using a screw, a bolt, or the like.

In some implementations, a guide post 503 configured to fit the guide hole 431 is provided on the top plate 56 of the guide support 50. There are a plurality of guide posts 503 and a plurality of guide holes 431. The plurality of guide posts 503 are arranged in a length direction of the top plate 56, and the plurality of guide holes 431 are distributed on the connection arm 43 in a length direction of the connection arm 43. Because the connection arm 43 is long, the plurality of guide holes 431 are provided, and the plurality of guide holes 431 are distributed on the connection arm 43 in the length direction of the connection arm 43, to ensure that all the plurality of first spring arms 41 of the spring arms can obtain a sufficient elastic force to press the power component 30 after mounting is completed.

In addition, a structure of a heat dissipation structure 20 in this embodiment is also different from that of the heat dissipation structure 20 in the embodiment in FIG. 2. In this embodiment, the heat dissipation structure 20 and the guide support 50 are integrally disposed. In other words, a part of the heat dissipation structure 20 is disposed as the guide support 50. The heat dissipation structure 20 includes a substrate 23, a heat dissipation plate 24 that is parallel with and spaced from the substrate 23, and a connection plate 25 that connects the heat dissipation plate 24 to the substrate 23. A direction perpendicular to the substrate 23 is the second direction X described above, and the heat dissipation plate 24 is of a long bar structure. A direction perpendicular to both a length direction of the heat dissipation plate 24 and the second direction X is the first direction Z described above, and ends of the substrate 23 and the heat dissipation plate 24 in the first direction Z are connected to the guide support 50. The guide support 50, the heat dissipation plate 24, the connection plate 25, and the substrate 23 form a heat dissipation through hole 505 by enclosing. The heat dissipation through hole 505 may convey a fluid, or may not convey a fluid, and another heat dissipation medium may alternatively be disposed. A plurality of power components 30 are spaced apart on a side that is of the heat dissipation plate 24 and that is away from the substrate 23.

In some implementations, the guide support 50 is approximately of a right-angled trapezoid structure. The guide support 50 includes the outer side face 51 in a foregoing embodiment, and an included angle formed between the outer side face 51 and the first end face 52 of the guide support 50 is an obtuse angle, so that the first spring arm 41 can be effectively and conveniently guided to the power component 30.

In some implementations, a circuit board 10 is fastened to the connection plate 25 and is spaced from the substrate 23.

It may be understood that, for a structure of the first spring arm 41, a limitation on a size between the first spring arm 41 and the connection arm 43, and the like in this embodiment, refer to the spring sheet 40 in the embodiment in FIG. 11. Details are not described herein again.

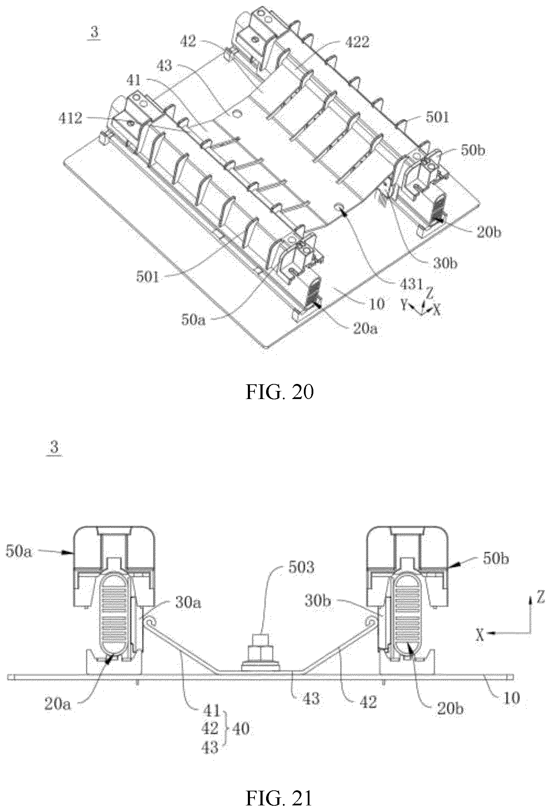

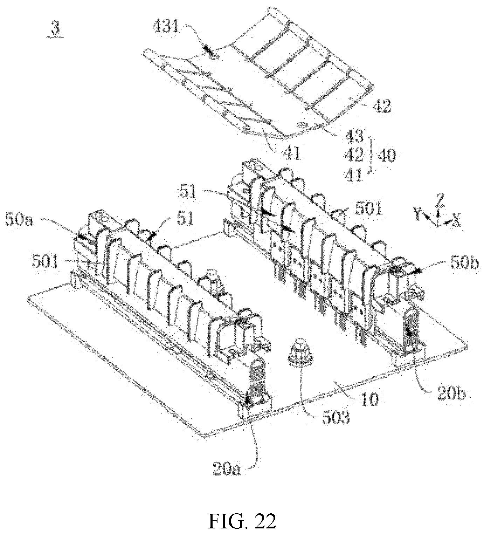

FIG. 20 is a diagram of a structure of still another mounting structure 3 of a power component according to an embodiment of this application. FIG. 21 is a front view of the mounting structure 3 of the power component in FIG. 20. FIG. 22 is a schematic exploded view of the mounting structure 3 of the power component in FIG. 20. The mounting structure 3 of the power component in the embodiment in FIG. 20 is an extended embodiment based on the mounting structure 3 of the power component in the embodiment in FIG. 2. The following focuses on characteristics of the mounting structure 3 of the power component in the embodiment in FIG. 20 that are different from those of the mounting structure 3 of the power component in the embodiment in FIG. 2. For parts that are not described emphatically or that are not described in the embodiment in FIG. 20, refer to the embodiments in FIG. 2 to FIG. 11. Details are not described again in the following.

Refer to FIG. 20 to FIG. 22. In some embodiments, the mounting structure 3 of the power component includes a circuit board 10, a first heat dissipation structure 20a, a second heat dissipation structure 20b, a first guide support 50a, a second guide support 50b, a first power component 30a, a second power component 30b, and a spring sheet 40.

The first heat dissipation structure 20a is located between the circuit board 10 and the first guide support 50a. The second heat dissipation structure 20b is located between the circuit board 10 and the second guide support 50b. The first heat dissipation structure 20a and the second heat dissipation structure 20b are spaced from each other in a second direction X. The first power component 30a is disposed on a side that is of the first heat dissipation structure 20a and that faces the second heat dissipation structure 20b. The second power component 30b is disposed on a side that is of the second heat dissipation structure 20b and that faces the first heat dissipation structure 20a. The spring sheet 40 is configured to synchronously press against the first power component 30a to the first heat dissipation structure 20a and press against the second power component 30b to the second heat dissipation structure 20b. An outer side face 51 of the first guide support 50a and an outer side face 51 of the second guide support 50b are configured to guide the spring sheet 40 to be mounted. A guiding manner is the same as that in the foregoing embodiments, and details are not described herein again.

In some implementations, both the first heat dissipation structure 20a and the second heat dissipation structure 20b are of long bar structures whose length directions are perpendicular to the second direction X. A plurality of first power components 30a are spaced apart on the first heat dissipation structure 20a in the length direction of the first heat dissipation structure 20a, and a plurality of second power components 30b are spaced apart on the second heat dissipation structure 20b in the length direction of the second heat dissipation structure 20b.

In some implementations, the spring sheet 40 includes a connection arm 43 and a plurality of first spring arms 41 and second spring arms 42 that are connected to the connection arm 43. The connection arm 43 is of a long bar structure whose length direction is the same as a length direction of the top plate 56 of the guide support 50. The connection arm 43 includes two opposite long edges in a second direction X, namely, two long edges of the connection arm 43 in the length direction. A plurality of first spring arms 41 are spaced apart on and connected to a long edge of the connection arm 43 in the length direction of the connection arm 43, and a plurality of second spring arms 42 are spaced apart on and connected to another long edge of the connection arm 43 in the length direction of the connection arm 43.

An included angle formed between a first connection part 413 of the first spring arm 41 and the connection arm 43 is an obtuse angle, and a pressing part 401 of the first spring arm 41 is located on a side that is of the first connection part 413 and that faces the second spring arm 42. An included angle formed between a second connection part 423 of the second spring arm 42 and the connection arm 43 is an obtuse angle, and a pressing part 401 of the second spring arm 42 is located on a side that is of the second connection part 423 and that faces the first spring arm 41.

The pressing part 401 of the first spring arm 41 of the spring sheet 40 presses against the first power component 30a. The pressing part 401 of the second spring arm 42 of the spring sheet 40 presses against the second power component 30b. The connection arm 43 of the spring sheet 40 is connected to the circuit board 10.

Compared with that in the foregoing embodiments, in this embodiment, the spring sheet 40 is alternatively mounted in a reverse expansion manner. In a mounting process of the spring sheet 40, the included angle formed between the first connection part 413 of the first spring arm 41 and the connection arm 43 gradually decreases, and the included angle formed between the second connection part 423 of the second spring arm 42 and the connection arm 43 gradually decreases, so that the inverted U-shaped spring sheet 40 is pressed down along the outer side face 51 of the first guide support 50a and the outer side face 51 of the second guide support 50b, to complete mounting.

It should be noted that the first heat dissipation structure 20a and the second heat dissipation structure 20b in this embodiment are equivalent to the heat dissipation structure 20 in the foregoing embodiments. The first guide support 50a and the second guide support 50b in this embodiment are equivalent to the guide support 50 in the foregoing embodiments. The first power component 30a and the second power component 30b in this embodiment are equivalent to the power component 30 in the foregoing embodiments, and details are not described herein again.

The foregoing descriptions are merely specific implementations of this application. Therefore, the protection scope of this application shall be subject to the protection scope of the claims.

## Claims

1. A power device (1), comprising a spring sheet (40), a power component (30), a circuit board (10), a guide support (50), and a heat dissipation structure (20) fastened between the circuit board (10) and the guide support (50), wherein the power component (30) comprises a main body part (31) and a pin (32), the pin (32) is configured to connect to the circuit board (10), a first surface (311) of the main body part (31) faces and is connected to the heat dissipation structure (20), and the guide support (50) and the pin (32) are distributed on two opposite sides of the main body part (31) in a first direction (Z);
the guide support (50) comprises an outer side face (51) disposed at an included angle with the first direction (Z); and
the spring sheet (40) comprises a pressing part (401), the pressing part (401) is configured to elastically press against a second surface (312) of the main body part (31), the outer side face (51) is configured to guide the pressing part (401) to the second surface (312) of the main body part (31), and the first surface (311) and the second surface (312) are disposed opposite to each other in a second direction (X);
wherein the guide support (50) comprises a first end face (52) and a second end face (53) that are disposed opposite to each other in the first direction (Z) and an outer side face (51) connected between the first end face (52) and the second end face (53), an area enclosed by an outer contour of the first end face (52) is less than an area enclosed by an outer contour of the second end face (53), the first end face (52) is located on a side that is of the second end face (53) and that is away from the main body part (31), and an included angle formed between the outer side face (51) and the first end face (52) is an obtuse angle; and
wherein the spring sheet (40) comprises a connection arm (43) and a first spring arm (41) connected to the connection arm (43), the first spring arm (41) comprises the pressing part (401), the connection arm (43) is configured to connect to the first end face (52), and the outer side face (51) is configured to increase an included angle between the connection arm (43) and the first spring arm (41).

2. The power device (1) according to claim 1, wherein the included angle formed between the outer side face (51) and the first end face (52) is B, and 92°B≤135°.

3. The power device (1) according to claim 1 or 2, wherein the second direction (Z) is perpendicular to the first direction (Z), the outer side face (51) comprises a first edge connected to the first end face (52) and a second edge connected to the second end face (53), the second surface (312) is located between the first surface (311) and the second edge in the second direction (Z), and a distance between the second edge and the second surface (312) in the second direction (Z) is L, wherein L is from 0 mm to 1 mm (including 0 mm and 1 mm).

4. The power device (1) according to any of claims 1 to 3, wherein the first spring arm (41) comprises a first arc corner part and a first connection part, the first arc corner part is of a circular arc structure, the first arc corner part is connected between the connection arm (43) and the first connection part, an end that is of the first connection part and that is away from the first arc corner part is connected to the pressing part (401) of the first spring arm (41), the pressing part (401) of the first spring arm (41) is a first pressing part (412), the first pressing part (412) comprises a first circular arc segment of a circular arc structure, an end of the first circular arc segment is connected to the end that is of the first connection part and that is away from the first arc corner part, and is tangent to the first connection part, the first circular arc segment is located on a side that is of the first connection part and that is away from the main body part (31), and the first circular arc segment presses against the second surface (312) of the main body part (31).

5. The power device (1) according to any one of claims 1 to 4, wherein the guide support (50) is of a long bar structure, and in a length direction of the guide support (50), a plurality of partition plates are spaced apart on the outer side face (51) of the guide support (50), and one first spring arm (41) is disposed between two adjacent partition plates.

6. The power device (1) according to any one of claims 1 to 5, wherein the guide support (50) comprises two outer side faces: a first outer side face (51) and a second outer side face (51), the first outer side face (51) and the second outer side face (51) are located on two opposite sides of the first end face (52) in the second direction (Z), the spring sheet (40) further comprises a second spring arm connected to the connection arm (43), the connection arm (43) is connected between the first spring arm (41) and the second spring arm in the second direction (Z), there are two pressing parts of the spring sheet (40): the first pressing part (412) and a second pressing part (422), the pressing part (401) of the first spring arm (41) is the first pressing part (412), the second spring arm comprises the second pressing part (422), the first outer side face (51) is configured to guide the first spring arm (41) to a second surface (312) of one main body part (31), and the second outer side face (51) is configured to guide the second spring arm to a second surface (312) of another main body part (31).

7. The power device (1) according to claim 6, wherein the second spring arm comprises a second arc corner part and a second connection part, the second arc corner part is connected between the connection arm (43) and the second connection part, and an end that is of the second connection part and that is away from the second arc corner part is connected to the second pressing part (422);
a distance, in the second direction (Z), between an end part that is of the first connection part and that is connected to the first arc corner part and an end part that is of the second connection part and that is connected to the second arc corner part is L1, wherein a range of L1 is 16 mm≤L1≤40 mm; or
an included angle A1 is formed between the connection arm (43) and the first connection part, wherein 45 degrees<A1<90 degrees; or
a length of the first connection part in the first direction (Z) is L2, wherein a range of L2 satisfies 20 mm≤L2≤40 mm.

8. The power device (1) according to claim 6 or 7, wherein the power device (1) further comprises an insulating heat-conducting plate (60), the insulating heat-conducting plate (60) is disposed between the main body part (31) and the heat dissipation structure (20), the first outer side face (51), the second outer side face (51), and the first end face (52) form an accommodation region by enclosing, and a part of the insulating heat-conducting plate (60) extends from the second end face (53) to the accommodation region.

9. The power device (1) according to claim 6, wherein the connection arm (43) is of a long bar structure whose length direction is the same as the length direction of the guide support (50), the connection arm (43) comprises two opposite long edges in the second direction (Z), a plurality of first spring arms are spaced apart on and connected to one of the long edges, and a plurality of second spring arms are spaced apart on and connected to the other of the long edges of the connection arm (43).

10. The power device (1) according to any one of claims 1 to 9, wherein the connection arm (43) is of a long bar structure whose length direction is the same as the length direction of the guide support (50), the connection arm (43) comprises two opposite long edges in the second direction (Z), a plurality of first spring arms are spaced apart on and connected to one of the long edges, a guide hole is provided on the connection arm (43), a guide post protruding in the first direction (Z) is disposed on the first end face (52) of the guide support (50), and the guide post is configured to fit the guide hole.

11. The power device (1) according to claim 10, wherein the heat dissipation structure (20) and the guide support (50) are integrally disposed, the heat dissipation structure (20) comprises a substrate, a heat dissipation plate that is in parallel with and spaced from the substrate, and a connection plate that connects the heat dissipation plate to the substrate, the heat dissipation plate is located between the guide support (50) and the connection plate in the first direction (Z), and the power component (30) is disposed on the heat dissipation plate.

12. The power device (1) according to claim 11, wherein the first direction (Z) is in parallel with the circuit board (10), and the circuit board (10) is connected to the heat dissipation structure (20) and is disposed in parallel with and spaced from the substrate.

13. The power device (1) according to any one of claims 1 to 3, wherein there are a plurality of power components, the plurality of power components comprise a first power component (30) and a second power component (30), there are a plurality of guide supports, the plurality of guide supports comprise a first guide support (50) and a second guide support (50), there are a plurality of heat dissipation structures, the plurality of heat dissipation structures comprise a first heat dissipation structure (20) and a second heat dissipation structure (20), the first heat dissipation structure (20) and the second heat dissipation structure (20) are spaced apart on the circuit board (10) in the second direction (Z), the circuit board (10) is disposed perpendicular to the first direction (Z), and the spring sheet (40) is located between the first heat dissipation structure (20) and the second heat dissipation structure (20) in the second direction (Z); and
the spring sheet (40) comprises a first pressing part (412) and a second pressing part (422), the first pressing part (412) is configured to elastically press against a second surface (312) of the first power component (30), an outer side face (51) of the first guide support (50) is configured to: guide the spring sheet (40) to move and open in a process of mounting the spring sheet (40), and guide the first pressing part (412) to the second surface (312) of the first power component (30), the second pressing part (422) is configured to elastically press against a second surface (312) of the second power component (30), and an outer side face (51) of the second guide support (50) is configured to: guide the spring sheet (40) to move and open in the process of mounting the spring sheet (40), and guide the second pressing part (422) to the second surface (312) of the second power component (30).

## Patentansprüche

1. Leistungsvorrichtung (1), die ein Federblech (40), eine Leistungskomponente (30), eine Leiterplatte (10), einen Führungsträger (50), und eine Wärmeableitungsstruktur (20) umfasst, die zwischen der Leiterplatte (10) und dem Führungsträger (50) befestigt ist, wobei die Leistungskomponente (30) ein Hauptkörperbauteil (31) und einen Stift (32) umfasst, wobei der Stift (32) konfiguriert ist, um mit der Leiterplatte (10) verbunden zu werden, wobei eine erste Oberfläche (311) des Hauptkörperbauteils (31) der Wärmeableitungsstruktur (20) zugewandt ist und mit dieser verbunden ist, und wobei der Führungsträger (50) und der Stift (32) in einer ersten Richtung (Z) auf zwei gegenüberliegenden Seiten des Hauptkörperbauteils (31) verteilt sind;
wobei der Führungsträger (50) eine äußere Seitenfläche (51) umfasst, die in einem mit der ersten Richtung (Z) eingeschlossenen Winkel angeordnet ist; und
wobei das Federblech (40) ein Einpressbauteil (401) umfasst, wobei das Einpressbauteil (401) konfiguriert ist, um elastisch gegen eine zweite Oberfläche (312) des Hauptkörperbauteils (31) zu drücken, wobei die äußere Seitenfläche (51) konfiguriert ist, um das Einpressbauteil (401) zu der zweiten Oberfläche (312) des Hauptkörperbauteils (31) zu führen, und wobei die erste Oberfläche (311) und die zweite Oberfläche (312) in einer zweiten Richtung (X) einander gegenüberliegend angeordnet sind;
wobei der Führungsträger (50) eine erste Endfläche (52) und eine zweite Endfläche (53), die in der ersten Richtung (Z) einander gegenüberliegend angeordnet sind, und eine äußere Seitenfläche (51) umfasst, die zwischen der ersten Endfläche (52) und der zweiten Endfläche (53) eingebunden ist, wobei ein Bereich, der von einer Außenkontur der ersten Endfläche (52) eingeschlossen wird, kleiner als ein Bereich ist, der von einer Außenkontur der zweiten Endfläche (53) eingeschlossen wird, wobei sich die erste Endfläche (52) auf einer Seite befindet, die zur zweiten Endfläche (53) gehört und die von dem Hauptkörperbauteil (31) entfernt ist, und wobei ein eingeschlossener Winkel, der zwischen der äußeren Seitenfläche (51) und der ersten Endfläche (52) gebildet ist, ein stumpfer Winkel ist; und
wobei das Federblech (40) einen Verbindungsarm (43) und einen ersten Federarm (41) umfasst, der mit dem Verbindungsarm (43) verbunden ist, wobei der erste Federarm (41) das Einpressbauteil (401) umfasst, wobei der Verbindungsarm (43) konfiguriert ist, um mit der ersten Endfläche (52) verbunden zu werden, und wobei die äußere Seitenfläche (51) konfiguriert ist, um einen eingeschlossenen Winkel zwischen dem Verbindungsarm (43) und dem ersten Federarm (41) zu vergrößern.

2. Leistungsvorrichtung (1) nach Anspruch 1, wobei der eingeschlossene Winkel, der zwischen der äußeren Seitenfläche (51) und der ersten Endfläche (52) gebildet wird, B ist und wobei 92°≤B≤135° ist.

3. Leistungsvorrichtung (1) nach Anspruch 1 oder 2, wobei die zweite Richtung (Z) senkrecht zur ersten Richtung (Z) ist, wobei die äußere Seitenfläche (51) einen ersten Rand, der mit der ersten Endfläche (52) verbunden ist, und einen zweiten Rand umfasst, der mit der zweiten Endfläche (53) verbunden ist, wobei sich die zweite Oberfläche (312) in der zweiten Richtung (Z) zwischen der ersten Oberfläche (311) und dem zweiten Rand befindet, und wobei ein Abstand zwischen dem zweiten Rand und der zweiten Oberfläche (312) in der zweiten Richtung (Z) L ist, wobei L von 0 mm bis 1 mm (wobei 0 mm und 1 mm eingeschlossen sind) reicht.

4. Leistungsvorrichtung (1) nach einem der Ansprüche 1 bis 3, wobei der erste Federarm (41) ein erstes Bogeneckbauteil und ein erstes Verbindungsbauteil umfasst, wobei das erste Bogeneckbauteil eine kreisförmige Bogenstruktur aufweist, wobei das erste Bogeneckbauteil zwischen dem Verbindungsarm (43) und dem ersten Verbindungsbauteil eingebunden ist, wobei ein Ende, das zu dem ersten Verbindungsbauteil gehört und das sich fern von dem ersten Bogeneckbauteil befindet, mit dem Einpressbauteil (401) des ersten Federarms (41) verbunden ist, wobei das Einpressbauteil (401) des ersten Federarms (41) ein erstes Einpressbauteil (412) ist, wobei das erste Einpressbauteil (412) ein erstes kreisförmiges Bogensegment einer kreisförmigen Bogenstruktur umfasst, wobei ein Ende des ersten kreisförmigen Bogensegments mit dem Ende verbunden ist, das zu dem ersten Verbindungsbauteil gehört und das sich fern von dem ersten Bogeneckbauteil befindet und das tangential zu dem ersten Verbindungsbauteil ist, wobei sich das erste kreisförmige Bogensegment auf einer Seite befindet, die zu dem ersten Verbindungsbauteil gehört und die sich fern von dem Hauptkörperbauteil (31) befindet, und wobei das erste kreisförmige Bogensegment gegen die zweite Oberfläche (312) des Hauptkörperbauteils (31) drückt.

5. Leistungsvorrichtung (1) nach einem der Ansprüche 1 bis 4, wobei der Führungsträger (50) eine lange Stabstruktur aufweist und wobei eine Vielzahl von Trennplatten auf der äußeren Seitenfläche (51) des Führungsträgers (50) in einer Längsrichtung des Führungsträgers (50) voneinander beabstandet sind und wobei ein erster Federarm (41) zwischen zwei benachbarten Trennplatten angeordnet ist.

6. Leistungsvorrichtung (1) nach einem der Ansprüche 1 bis 5, wobei der Führungsträger (50) zwei äußere Seitenflächen umfasst: eine erste äußere Seitenfläche (51) und eine zweite äußere Seitenfläche (51), wobei sich die erste äußere Seitenfläche (51) und die zweite äußere Seitenfläche (51) in der zweiten Richtung (Z) auf zwei gegenüberliegenden Seiten der ersten Endfläche (52) befinden, wobei das Federblech (40) ferner einen zweiten Federarm umfasst, der mit dem Verbindungsarm (43) verbunden ist, wobei der Verbindungsarm (43) in der zweiten Richtung (Z) zwischen dem ersten Federarm (41) und dem zweiten Federarm eingebunden ist, wobei zwei Einpressbauteile des Federblechs (40) vorhanden sind: das erste Einpressbauteil (412) und ein zweites Einpressbauteil (422), wobei das Einpressbauteil (401) des ersten Federarms (41) das erste Einpressbauteil (412) ist, wobei der zweite Federarm das zweite Einpressbauteil (422) umfasst, wobei die erste äußere Seitenfläche (51) konfiguriert ist, um den ersten Federarm (41) zu einer zweiten Oberfläche (312) von einem Hauptkörperbauteil (31) zu führen, und wobei die zweite äußere Seitenfläche (51) konfiguriert ist, um den zweiten Federarm zu einer zweiten Oberfläche (312) eines anderen Hauptkörperbauteils (31) zu führen.

7. Leistungsvorrichtung (1) nach Anspruch 6, wobei der zweite Federarm ein zweites Bogeneckbauteil und ein zweites Verbindungsbauteil umfasst, wobei das zweite Bogeneckbauteil zwischen dem Verbindungsarm (43) und dem zweiten Verbindungsbauteil eingebunden ist und wobei ein Ende, das zu dem zweiten Verbindungsteil gehört und das sich fern von dem zweiten Bogeneckbauteil befindet, mit dem zweiten Einpressbauteil (422) verbunden ist;
wobei ein Abstand in der zweiten Richtung (Z) zwischen einem Endabschnitt, der zu dem ersten Verbindungsbauteil gehört und der mit dem ersten Bogeneckbauteil verbunden ist, und einem Endabschnitt, der zu dem zweiten Verbindungsbauteil gehört und der mit dem zweiten Bogeneckbauteil verbunden ist, L1 ist, wobei ein Bereich von L1 16 mm≤L1≤40 mm ist; oder
wobei zwischen dem Verbindungsarm (43) und dem ersten Verbindungsbauteil ein eingeschlossener Winkel A1 gebildet wird, wobei 45 Grad≤A1≤90 Grad ist; oder
wobei eine Länge des ersten Verbindungsbauteils in der ersten Richtung (Z) L2 ist, wobei ein Bereich von L2 20 mm≤L2≤40 mm erfüllt.

8. Leistungsvorrichtung (1) nach Anspruch 6 oder 7, wobei die Leistungsvorrichtung (1) ferner eine isolierende wärmeleitende Platte (60) umfasst, wobei die isolierende wärmeleitende Platte (60) zwischen dem Hauptkörperbauteil (31) und der Wärmeableitungsstruktur (20) angeordnet ist, wobei die erste äußere Seitenfläche (51), die zweite äußere Seitenfläche (51) und die erste Endfläche (52) ein Aufnahmegebiet bilden, indem sie zusammengeschlossen werden, und wobei sich ein Teil der isolierenden Wärmeleitplatte (60) von der zweiten Endfläche (53) bis zu dem Aufnahmegebiet erstreckt.

9. Leistungsvorrichtung (1) nach Anspruch 6, wobei der Verbindungsarm (43) eine lange Stabstruktur aufweist, deren Längsrichtung die gleiche wie die Längsrichtung des Führungsträgers (50) ist, wobei der Verbindungsarm (43) zwei einander gegenüberliegende lange Ränder in der zweiten Richtung (Z) umfasst, wobei eine Vielzahl von ersten Federarmen an einem der langen Ränder voneinander beabstandet und mit diesem verbunden sind, und wobei eine Vielzahl von zweiten Federarmen an dem anderen der langen Ränder des Verbindungsarms (43) voneinander beabstandet und mit diesem verbunden sind.

10. Leistungsvorrichtung (1) nach einem der Ansprüche 1 bis 9, wobei der Verbindungsarm (43) eine lange Stabstruktur aufweist, deren Längsrichtung die gleiche wie die Längsrichtung des Führungsträgers (50) ist, wobei der Verbindungsarm (43) zwei einander gegenüberliegende lange Ränder in der zweiten Richtung (Z) umfasst, wobei eine Vielzahl von ersten Federarmen an einem der langen Ränder voneinander beabstandet und mit diesem verbunden sind, wobei an dem Verbindungsarm (43) eine Führungsöffnung bereitgestellt wird, wobei an der ersten Endfläche (52) des Führungsträgers (50) ein Führungszapfen angeordnet ist, der in der ersten Richtung (Z) herausragt, und wobei der Führungszapfen konfiguriert ist, um in die Führungsöffnung zu passen.

11. Leistungsvorrichtung (1) nach Anspruch 10, wobei die Wärmeableitungsstruktur (20) und der Führungsträger (50) als integrales Bauteil angeordnet sind, wobei die Wärmeableitungsstruktur (20) ein Substrat, eine Wärmeableitungsplatte, die sich parallel zu dem Substrat befindet und von diesem beabstandet ist, und eine Verbindungsplatte umfasst, welche die Wärmeableitungsplatte mit dem Substrat verbindet, wobei sich die Wärmeableitungsplatte in der ersten Richtung (Z) zwischen dem Führungsträger (50) und der Verbindungsplatte befindet, und wobei die Leistungskomponente (30) auf der Wärmeableitungsplatte angeordnet ist.

12. Leistungsvorrichtung (1) nach Anspruch 11, wobei die erste Richtung (Z) parallel zu der Leiterplatte (10) ist und die Leiterplatte (10) mit der Wärmeableitungsstruktur (20) verbunden ist und parallel zu dem Substrat und beabstandet von diesem angeordnet ist.

13. Leistungsvorrichtung (1) nach einem der Ansprüche 1 bis 3, wobei eine Vielzahl von Leistungskomponenten vorhanden ist, wobei die Vielzahl von Leistungskomponenten eine erste Leistungskomponente (30) und eine zweite Leistungskomponente (30) umfassen, wobei eine Vielzahl von Führungsträgern vorhanden ist, wobei die Vielzahl von Führungsträgern einen ersten Führungsträger (50) und einen zweiten Führungsträger (50) umfassen, wobei eine Vielzahl von Wärmeableitungsstrukturen vorhanden ist, wobei die Vielzahl von Wärmeableitungsstrukturen eine erste Wärmeableitungsstruktur (20) und eine zweite Wärmeableitungsstruktur (20) umfassen, wobei die erste Wärmeableitungsstruktur (20) und die zweite Wärmeableitungsstruktur (20) auf der Leiterplatte (10) in der zweiten Richtung (Z) voneinander beabstandet sind, wobei die Leiterplatte (10) senkrecht zur ersten Richtung (Z) angeordnet ist, und wobei sich das Federblech (40) in der zweiten Richtung (Z) zwischen der ersten Wärmeableitungsstruktur (20) und der zweiten Wärmeableitungsstruktur (20) befindet; und
wobei das Federblech (40) ein erstes Einpressbauteil (412) und ein zweites Einpressbauteil (422) umfasst, wobei das erste Einpressbauteil (412) konfiguriert ist, um elastisch gegen eine zweite Oberfläche (312) der ersten Leistungskomponente (30) zu drücken, wobei eine äußere Seitenfläche (51) des ersten Führungsträgers (50) konfiguriert ist zum: Führen des Federblechs (40), um sich in einem Prozess eines Montierens des Federblechs (40) zu bewegen und zu öffnen; und Führen des ersten Einpressbauteils (412) zu der zweiten Oberfläche (312) der ersten Leistungskomponente (30), wobei das zweite Einpressbauteil (422) konfiguriert ist, um elastisch gegen eine zweite Oberfläche (312) der zweiten Leistungskomponente (30) zu drücken, und wobei eine äußere Seitenfläche (51) des zweiten Führungsträgers (50) konfiguriert ist zum: Führen des Federblechs (40), um sich in einem Prozess eines Montierens des Federblechs (40) zu bewegen und zu öffnen; und Führen des zweiten Einpressbauteils (422) zu der zweiten Oberfläche (312) der zweiten Leistungskomponente (30).

## Revendications

1. Dispositif de puissance (1), comprenant une lame ressort (40), un composant de puissance (30), une carte de circuit (10), un support de guidage (50), et une structure de dissipation thermique (20) fixée entre la carte de circuit (10) et le support de guidage (50), le composant de puissance (30) comprenant une partie de corps principale (31) et une broche (32), la broche (32) étant configurée pour se connecter à la carte de circuit (10), une première surface (311) de la partie de corps principale (31) faisant face et étant connectée à la structure de dissipation thermique (20), et le support de guidage (50) et la broche (32) étant répartis sur deux côtés opposés de la partie de corps principale (31) dans une première direction (Z) ;
le support de guidage (50) comprend une face latérale extérieure (51) disposée selon un angle inclus avec la première direction (Z) ; et
la lame ressort (40) comprend une partie d'appui (401), la partie d'appui (401) est configurée pour appuyer élastiquement contre une deuxième surface (312) de la partie de corps principale (31), la face latérale extérieure (51) est configurée pour guider la partie d'appui (401) vers la deuxième surface (312) de la partie de corps principale (31), et la première surface (311) et la deuxième surface (312) sont disposées à l'opposé l'une de l'autre dans une deuxième direction (X) ;
dans lequel le support de guidage (50) comprend une première face d'extrémité (52) et une deuxième face d'extrémité (53) disposées à l'opposé l'une de l'autre dans la première direction (Z) et une face latérale extérieure (51) connectée entre la première face d'extrémité (52) et la deuxième face d'extrémité (53), une aire entourée par un contour extérieur de la première face d'extrémité (52) est inférieure à une aire entourée par un contour extérieur de la deuxième face d'extrémité (53), la première face d'extrémité (52) est située sur un côté de la deuxième face d'extrémité (53) et éloignée de la partie de corps principale (31), et un angle inclus formé entre la face latérale externe (51) et la première face d'extrémité (52) est un angle obtus ; et
dans lequel la lame ressort (40) comprend un bras de connexion (43) et un premier bras ressort (41) connecté au bras de connexion (43), le premier bras ressort (41) comprend la partie d'appui (401), le bras de connexion (43) est configuré pour se connecter à la première face d'extrémité (52), et la face latérale extérieure (51) est configurée pour augmenter un angle inclus entre le bras de connexion (43) et le premier bras ressort (41).

2. Dispositif de puissance (1) selon la revendication 1, dans lequel l'angle inclus formé entre la face latérale extérieure (51) et la première face d'extrémité (52) est B, et 92°≤B≤135°.

3. Dispositif de puissance (1) selon la revendication 1 ou 2, dans lequel la deuxième direction (Z) est perpendiculaire à la première direction (Z), la face latérale extérieure (51) comprend un premier bord connecté à la première face d'extrémité (52) et un deuxième bord connecté à la deuxième face d'extrémité (53), la deuxième surface (312) est située entre la première surface (311) et le deuxième bord dans la deuxième direction (Z), et une distance entre le deuxième bord et la deuxième surface (312) dans la deuxième direction (Z) est L, où L va de 0 mm à 1 mm (y compris 0 mm et 1 mm).

4. Dispositif de puissance (1) selon l'une quelconque des revendications 1 à 3, dans lequel le premier bras de ressort (41) comprend une première partie d'angle d'arc et une première partie de connexion, la première partie d'angle d'arc fait partie d'une structure d'arc circulaire, la première partie d'angle d'arc est connectée entre le bras de connexion (43) et la première partie de connexion, une extrémité de la première partie de connexion et opposée à la première partie d'angle d'arc est connectée à la partie d'appui (401) du premier bras ressort (41), la partie d'appui (401) du premier bras ressort (41) est une première partie d'appui (412), la première partie d'appui (412) comprend un premier segment d'arc circulaire d'une structure d'arc circulaire, une extrémité du premier segment d'arc circulaire est connectée à l'extrémité de la première partie de connexion et opposée à la première partie d'angle d'arc, et tangente à la première partie de connexion, le premier segment d'arc circulaire est situé sur un côté de la première partie de connexion et opposé à la partie de corps principale (31), et le premier segment d'arc circulaire est en appui contre la deuxième surface (312) de la partie de corps principale (31).

5. Dispositif de puissance (1) selon l'une quelconque des revendications 1 à 4, dans lequel le support de guidage (50) est d'une structure barre longue, et dans une direction de longueur du support de guidage (50), une pluralité de plaques de séparation sont espacées sur la face latérale extérieure (51) du support de guidage (50), et un premier bras de ressort (41) est disposé entre deux plaques de séparation adjacentes.

6. Dispositif de puissance (1) selon l'une quelconque des revendications 1 à 5, dans lequel le support de guidage (50) comprend deux faces latérales extérieures : une première face latérale extérieure (51) et une deuxième face latérale extérieure (51), la première face latérale extérieure (51) et la deuxième face latérale extérieure (51) sont situées sur deux côtés opposés de la première face d'extrémité (52) dans la deuxième direction (Z), la lame ressort (40) comprend en outre un deuxième bras de ressort connecté au bras de connexion (43), le bras de connexion (43) est connecté entre le premier bras de ressort (41) et le deuxième bras de ressort dans la deuxième direction (Z), il y a deux parties d'appui de la lame élastique (40): la première partie d'appui (412) et une deuxième partie d'appui (422), la partie d'appui (401) du premier bras de ressort (41) étant la première partie d'appui (412), le deuxième bras de ressort comprenant la deuxième partie d'appui (422), la première face latérale extérieure (51) étant configurée pour guider le premier bras de ressort (41) vers une deuxième surface (312) d'une partie de corps principal (31), et la deuxième face latérale extérieure (51) étant configurée pour guider le deuxième bras de ressort vers une deuxième surface (312) d'une autre partie de corps principale (31).

7. Dispositif de puissance (1) selon la revendication 6, dans lequel le deuxième bras de ressort comprend une deuxième partie d'angle d'arc et une deuxième partie de connexion, la deuxième partie d'angle d'arc est connectée entre le bras de connexion (43) et la deuxième partie de connexion, et une extrémité de la deuxième partie de connexion et éloignée de la deuxième partie d'angle d'arc est connectée à la deuxième partie d'appui (422) ;
une distance, dans la deuxième direction (Z), entre une partie d'extrémité de la première partie de connexion et connectée à la première partie d'angle d'arc et une partie d'extrémité de la deuxième partie de connexion et connectée à la deuxième partie d'angle d'arc est L1, où une plage de L1 est 16 mm≤L1≤40 mm ; ou
un angle inclus A1 est formé entre le bras de connexion (43) et la première partie de connexion, où 45 degrés≤A1≤90 degrés ; ou
une longueur de la première partie de connexion dans la première direction (Z) est L2, où une plage de L2 satisfait 20 mm≤L2≤40 mm.

8. Dispositif de puissance (1) selon la revendication 6 ou 7, dans lequel le dispositif de puissance (1) comprend en outre une plaque thermoconductrice isolante (60), la plaque thermoconductrice isolante (60) est disposée entre la partie de corps principal (31) et la structure de dissipation thermique (20), la première face latérale extérieure (51), la deuxième face latérale extérieure (51), et la première face d'extrémité (52) forment une région d'accueil en entourant, et une partie de la plaque thermoconductrice isolante (60) s'étend de la deuxième face d'extrémité (53) à la région d'accueil.

9. Dispositif de puissance (1) selon la revendication 6, dans lequel le bras de connexion (43) est d'une structure barre longue dont la direction de longueur est la même que la direction de longueur du support de guidage (50), le bras de connexion (43) comprend deux bords longs opposés dans la deuxième direction (Z), une pluralité de premiers bras de ressort sont espacés et connectés à l'un des bords longs, et une pluralité de deuxièmes bras de ressort sont espacés et connectés à l'autre des bords longs du bras de connexion (43).

10. Dispositif de puissance (1) selon l'une quelconque des revendications 1 à 9, dans lequel le bras de connexion (43) fait partie d'une structure barre longue dont la direction de longueur est la même que la direction de longueur du support de guidage (50), le bras de connexion (43) comprend deux bords longs opposés dans la deuxième direction (Z), une pluralité de premiers bras de ressort sont espacés et connectés à l'un des bords longs, un trou de guidage est prévu sur le bras de connexion (43), un montant de guidage faisant saillie dans la première direction (Z) est disposé sur la première face d'extrémité (52) du support de guidage (50), et le montant de guidage est configuré pour s'adapter au trou de guidage.

11. Dispositif de puissance (1) selon la revendication 10, dans lequel la structure de dissipation thermique (20) et le support de guidage (50) sont disposés d'un seul tenant, la structure de dissipation thermique (20) comprend un substrat, une plaque de dissipation thermique qui est parallèle au et espacée du substrat, et une plaque de connexion qui connecte la plaque de dissipation thermique au substrat, la plaque de dissipation thermique est située entre le support de guidage (50) et la plaque de connexion dans la première direction (Z), et le composant de puissance (30) est disposé sur la plaque de dissipation thermique.

12. Dispositif de puissance (1) selon la revendication 11, dans lequel la première direction (Z) est parallèle à la carte de circuit (10), et la carte de circuit (10) est connectée à la structure de dissipation thermique (20) et est disposée en parallèle au et espacée du substrat .

13. Dispositif de puissance (1) selon l'une quelconque des revendications 1 à 3, dans lequel il y a une pluralité de composants de puissance, la pluralité de composants de puissance comprenant un premier composant de puissance (30) et un deuxième composant de puissance (30), il y a une pluralité de supports de guidage, la pluralité de supports de guidage comprend un premier support de guidage (50) et un deuxième support de guidage (50), il y a une pluralité de structures de dissipation thermique, la pluralité de structures de dissipation thermique comprend une première structure de dissipation thermique (20) et une deuxième structure de dissipation thermique (20), la première structure de dissipation thermique (20) et la deuxième structure de dissipation thermique (20) sont espacées sur la carte de circuit (10) dans la deuxième direction (Z), la carte de circuit (10) est disposée perpendiculairement à la première direction (Z), et la lame ressort (40) est située entre la première structure de dissipation thermique (20) et la deuxième structure de dissipation thermique (20) dans la deuxième direction (Z) ; et
la lame ressort (40) comprend une première partie d'appui (412) et une deuxième partie d'appui (422), la première partie d'appui (412) est configurée pour appuyer élastiquement contre une deuxième surface (312) du premier composant de puissance (30), une face latérale externe (51) du premier support de guidage (50) est configurée pour : guider la lame ressort (40) pour se déplacer et s'ouvrir lors d'un processus de montage de la lame ressort (40), et guider la première partie d'appui (412) sur la deuxième surface (312) du premier composant de puissance (30), la deuxième partie d'appui (422) est configurée pour appuyer élastiquement contre une deuxième surface (312) du deuxième composant de puissance (30), et une face latérale externe (51) du deuxième support de guidage (50) est configurée pour : guider la lame ressort (40) pour se déplacer et s'ouvrir lors du montage de la lame ressort (40), et guider la deuxième partie d'appui (422) vers la deuxième surface (312) du deuxième composant de puissance (30).
